# EUROPEAN PATENT SPECIFICATION

(11) **EP 2 923 377 B1**
(45) Date of publication and mention of the grant of the patent: **12.06.2019**
(21) Application number: 13801948.4
(22) Date of filing: 21.11.2013
(51) Int. Cl.: H01L 27/10, H01L 23/525, G11C 17/16, G11C 17/18, H01L 27/112

(54) **INTEGRATED CIRCUIT DEVICE AND METHOD FOR MAKING SAME**
VORRICHTUNG MIT EINEM INTEGRIERTEN SCHALTKREIS UND VERFAHREN ZUR HERSTELLUNG DAVON
DISPOSITIF DE CIRCUIT INTÉGRÉ ET PROCÉDÉ PERMETTANT DE FABRIQUER CE DERNIER

(30) Priority: 21.11.2012 US 201213684087
(43) Date of publication of application: 30.09.2015
(73) Proprietor: Qualcomm Incorporated, San Diego, CA 92121 (US)
(72) Inventor: WANG, Zhongze, San Diego, California 92121 (US)
(74) Representative: Dunlop, Hugh Christopher
(86) International application number: PCT/US2013/071350
(87) International publication number: WO 2014/081984

(56) References cited:
- WO-A1-2010/098952
- WO-A1-2012/134585
- KR-A- 20100 098 484
- US-A1- 2006 067 152
- US-A1- 2006 121 742
- US-A1- 2008 185 723
- US-A1- 2008 237 673
- US-A1- 2009 026 576
- US-A1- 2010 032 732
- US-A1- 2011 255 327
- US-A1- 2011 309 421
- US-A1- 2012 012 943
- US-A1- 2012 091 557
- US-A1- 2012 147 653
- US-B1- 6 441 676

## Description

### BACKGROUND

### Field

Various features relate to integrated circuits, and more particularly to integrated circuit antifuses.

### Background

Integrated circuits (ICs) are interconnected networks of electrical components fabricated on a common foundation called a substrate. The substrate is typically a wafer of semiconductor material, such as silicon. Various fabrication techniques, such as layering, doping, masking, and etching, are used to build millions of resistors, transistors, and other electrical components on the wafer. The components are then wired together, or interconnected, to define a specific electrical circuit, such as a processor or a memory device.

The document US2006/0121742 discloses a CMOS integrated circuit comprising a metal gate formed on a high-k gate dielectric layer.

Fusible elements are employed in integrated circuits to permit changes in the configuration of the integrated circuits after fabrication. For example, fusible elements may be used to replace defective circuits with redundant circuits. As another example, fusible elements may be used to create one time programmable (OTP) or multi-time programmable (MTP) memory circuits. Individual memory cells of an OTP memory cell may be written to once in order to create read only memory modules that cannot be easily altered and/or are secure.

One type of fusible element is a metal fuse. The metal fuse is composed of a metal alloy or metal, such as copper, that may change its state from a conductive, closed circuit state to a substantially non-conductive, open circuit state if a sufficient amount of current flows through the metal fuse. Metal fuses have several disadvantages. For example, the current needed to program the fuse (i.e., blow the fuse to change it from a closed circuit state to an open circuit state) is relatively high. Generating this current consumes a substantial amount of power, particularly for mobile devices where power consumption is a concern. Moreover, relatively large transistors (i.e., transistors having a large chip area) are required to generate the current drive needed to blow the metal fuses. Additionally, metal fuses provide poor security because the blown fuses may, in some cases, be seen optically. Also, metal fuses offer poor reliability and in some cases may require serial programming.

Another type of fusible element is an antifuse. An antifuse comprises two conductive terminals separated by an insulator or a dielectric, and is fabricated as an open circuit. The antifuse is programmed by applying a high voltage across its terminals to rupture the insulator and form an electrical path between the terminals. A gate dielectric antifuse may be a metal oxide semiconductor field effect transistor (MOSFET) that is designed such that the gate oxide located between the transistor's gate terminal and the body or between the gate terminal and the source/drain terminal breaks down (i.e., ruptures) after a sufficiently high voltage is applied.

The document US2009/0026576 discloses an anti-fuse based on a MOSFET structure comprising a gate and source/drain regions. The document WO2012/134585 discloses methods of forming secured metal gate antifuse structures.

Typical prior art gate dielectric antifuses used for programmable memory cells may require a relatively high voltage to change the state of the antifuse from an open circuit state to a closed circuit state (i.e., programming the antifuse). Typically, the voltage needed to program the antifuse is generated using a charge pump. However, charge pumps may vary in design complexity and consume valuable, on-chip active surface area that may otherwise be used for other active components, such as memory cells. Reducing the programming voltage *V_{PP}* needed to program antifuse circuits is therefore desirable.

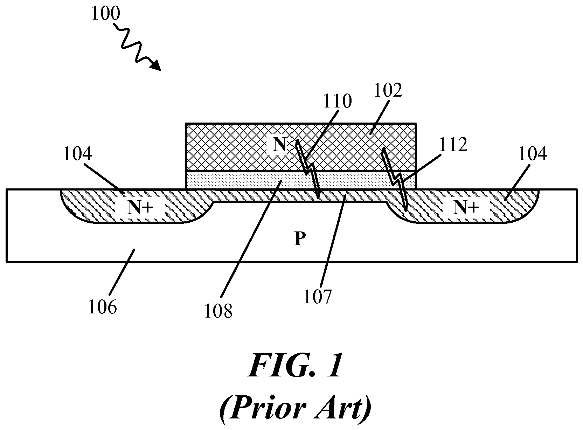

FIG. 1 illustrates a typical IC gate oxide antifuse 100 found in the prior art. The antifuse 100 comprises a gate terminal 102, source or drain terminals 104 (e.g., source/drain terminals), a substrate body terminal 106, and a gate oxide 108. The antifuse 100 is a typical polysilicon process NMOS transistor. The gate terminal 102 is largely composed of an "n-type" doped polysilicon semiconductor (that may have an outer metal silicide layer), the gate oxide 108 is composed of silicon oxide, and the source and drain terminals 104 (hereinafter "source/drain") are heavily doped "n+" regions within a "p-type" well/substrate body 106.

If the voltage across the gate oxide 108 at any point along its thickness exceeds the gate breakdown voltage *V_{BD},* then the gate oxide 108 will break down (e.g., plasma channels may form) and a short circuit will be created through the gate oxide 108. The break down may occur at one or more points along the gate oxide 108 between the gate 102 and the body 106 (or inversion layer channel 107) and/or between the gate 102 and a source/drain 104 terminal, thereby creating different types of conduction paths. In the illustrated example, one conduction path 110 represents an indirect short circuit path created between the gate 102 and the source/drain 104 where current must first flow through the inversion layer channel 107 above the body 106 before it reaches the source/drain 104 (a voltage between the gate 102 and the body 106 exceeding the threshold voltage *V_{TH}* of the antifuse 100 may be assumed). By contrast, the other conduction path 112 represents a direct short circuit path created between the gate 102 and the source/drain 104.

If the antifuse's source/drain terminals 104 are grounded, and the gate terminal 102 voltage exceeds *V_{TH},* then the voltage potential across the gate oxide 108 is substantially uniform. For example, the voltage between the gate 102 and the channel 107 is very close to or the same as the voltage between the gate 102 and the source/drain terminals 104. Consequently, if the voltage at the gate 102 is raised so that it exceeds the breakdown voltage *V_{BD}* of the gate oxide 108, then any one of the conduction paths 110, 112 are substantially equally likely when the gate oxide 108 breaks down.

Each conduction path 110, 112 has a resistance associated with it. For example, the direct conduction path 112 from the gate 102 to the source/drain 104 has less resistance than the indirect conduction path 110 from the gate 102 to the channel 107 because the direct path 112 is shorter. By contrast, the indirect conduction path 110 may have a higher resistance than the direct conduction path 112 because the indirect path 110 includes a portion that runs through the channel 107 before it couples to the source/drain 104.

Once the antifuse 100 has been programmed (i.e., the gate oxide 108 has broken down), the amount of current flow from the gate 102 through the source/drain 104 is directly proportional to the resistance of the conduction path(s) 110, 112 created. Sensing circuits (not shown) that read the logical state of the antifuse 100 measure the current flow through the antifuse 100 to determine whether it has been programmed. Little or no current flow (i.e., open circuit) through the antifuse 100 means the antifuse 100 has not been programmed, while substantial current flow (i.e., short circuit) means it has been programmed. Since the formation of the indirect and direct conduction paths 110, 112 is substantially equally likely, it is practically impossible to predict exactly which type of conduction path 110, 112-direct or indirect-will result when the gate oxide 108 breaks down. Therefore, it is very difficult to predict what the post-breakdown resistance of the antifuse 100 will be, and the post-breakdown resistance value distribution (i.e., range of post-breakdown resistance values) will be relatively large/broad. Consequently, the range of current flow values through the antifuse 100 representing a programmed state may also be large/broad. A broad current flow range representing a programmed logical state may cause the sensing circuits (not shown) to misread the actual logical state of the antifuse 100.

By contrast, a small/narrow post-breakdown resistance value distribution leads to a small/narrow range of current values that can flow through the antifuse 100 after programming. Such a narrow range may help assure an accurate logic state reading by the sensing circuits. Thus, reducing the post-breakdown resistance value distribution/range is desirable.

Therefore, there exists a need for advanced antifuse structures that both lower the programming voltage *V_{PP}* needed to program an antifuse, and also reduce the post-breakdown resistance value distribution of the antifuse so that sensing circuits can accurately and reliably read the logical state of the antifuse.

### SUMMARY

An integrated circuit antifuse is disclosed as recited in claim 1. A method of manufacturing an integrated circuit antifuse is disclosed as recited in claim 18. Further embodiments are recited in the dependent claims.

One feature provides an integrated circuit (IC) that includes a metal gate terminal that has a gate metal that is either p-type or n-type. The IC further includes a first semiconductor region having either a p-type doping or an n-type doping, such that if the gate metal is p-type then the first semiconductor region has the n-type doping, and if the gate metal is n-type then the first semiconductor region has the p-type doping. A gate dielectric is interposed between the metal gate terminal and the first semiconductor region. The gate dielectric has a gate breakdown voltage *V_{BDGSD}* that is reduced in proportion to a built-in electric field *E_{BIGSD}* associated with a boundary region between the metal gate terminal and the first semiconductor region if a polarity of a programming voltage *V_{PP}* is oriented parallel to the built-in electric field *E_{BIGSD}*

Another feature provides an integrated circuit (IC) that comprises a metal gate terminal that includes a gate metal that is either p-type or n-type, a first semiconductor region having either a p-type doping or an n-type doping, such that if the gate metal is p-type then the first semiconductor region has the n-type doping, and if the gate metal is n-type then the first semiconductor region has the p-type doping, and a gate dielectric interposed between the metal gate terminal and the first semiconductor region. According to one aspect, the IC further comprises a semiconductor substrate body having either a p-type doping or an n-type doping, such that if the gate metal is p-type then the substrate body has the p-type doping, and if the gate metal is n-type then the substrate body has the n-type doping, the first semiconductor region disposed in the semiconductor substrate body, a portion of the first semiconductor region below a first side of the metal gate terminal. According to another aspect, the IC further comprises a second semiconductor region having either a p-type doping or an n-type doping, such that if the gate metal is p-type then the second semiconductor region has the n-type doping, and if the gate metal is n-type then the second semiconductor region has the p-type doping, the second semiconductor region disposed in the semiconductor substrate body, where a portion of the second semiconductor region below a second side of the metal gate terminal.

According to one aspect, the IC further comprises a short trench isolation barrier disposed in the semiconductor substrate body, where a portion of the short trench isolation barrier below a second side of the metal gate terminal. According to another aspect, the gate dielectric is a high-*K* dielectric material having a dielectric constant greater than or equal to ten (10). According to yet another aspect, the gate dielectric comprises at least one of hafnium oxide (HfO₂), hafnium silicon oxide (HfSiO), and/or hafnium silicate (HfSiO₄). According to yet another aspect, the gate metal is p-type and the gate metal comprises at least one of titanium nitride (TiN) and/or titanium carbide (TiC). According to yet another aspect, the gate metal is n-type and the gate metal comprises at least one of titanium aluminum nitride (TiAlN), titanium aluminide (TiAl), zirconium aluminide (ZrAl), and/or tungsten aluminide (WAl). According to yet another aspect, a first gate breakdown voltage *V_{BDGSD}* at a boundary region between the metal gate terminal and the first semiconductor region is less than a second gate breakdown voltage *V_{BDGB}* at a boundary region between the metal gate terminal and a semiconductor substrate body.

According to one aspect, the integrated circuit is an antifuse, and the gate dielectric is adapted to breakdown and create a conductive path between the metal gate terminal and the first semiconductor region if a programming voltage *V_{PP}* between the metal gate terminal and the first semiconductor region is equal to or exceeds a gate breakdown voltage *V_{BDGSD}.* According to another aspect, the antifuse is part of a one-time programmable memory (OTP) circuit, and the conductive path is irreversible. According to yet another aspect, the antifuse is part of a multi-time programmable memory (MTP) circuit, and the conductive path is reversible. According to yet another aspect, a probability that the conductive path forms at a boundary region between the metal gate terminal and the first semiconductor region is greater than a probability that the conductive path forms at a boundary region between the metal gate terminal and a semiconductor substrate body below the gate dielectric. According to yet another aspect, the gate breakdown voltage *V_{BDGSD}* is reduced in proportion to a built-in electric field *E_{BIGSD}* associated with a boundary region between the metal gate terminal and the first semiconductor region. According to yet another aspect, the programming voltage *V_{PP}* is reduced if a polarity of the programming voltage *V_{PP}* is oriented parallel to the built-in electric field *E_{BIGSD}.*

According to one aspect, a logical value stored at the antifuse is adapted to be read when a voltage equal to or exceeding a read voltage *V_{RD}* is applied between the first semiconductor region and the metal gate terminal, the voltage applied having a polarity oriented opposite to the built-in electric field *E_{BIGSD}.* According to another aspect, the integrated circuit is incorporated into at least one of a music player, a video player, an entertainment unit, a navigation device, a communications device, a mobile phone, a smartphone, a personal digital assistant, a fixed location terminal, a tablet computer, and/or a laptop computer.

Another feature provides a method of manufacturing an integrated circuit that comprises providing a semiconductor substrate body, forming a first semiconductor region in the semiconductor substrate body, the first semiconductor region having either a p-type doping or an n-type doping, forming a gate dielectric over at least a portion of the first semiconductor region, and forming a metal gate terminal that includes a gate metal that is either p-type or n-type over the gate dielectric, wherein if the gate metal is p-type then the first semiconductor region has the n-type doping, and if the gate metal is n-type then the first semiconductor region has the p-type doping. According to one aspect, the semiconductor substrate body has either a p-type doping or an n-type doping, such that if the gate metal is p-type then the substrate body has the p-type doping, and if the gate metal is n-type then the substrate body has the n-type doping, and the method further comprises disposing the first semiconductor region in the semiconductor substrate body, a portion of the first semiconductor region below a first side of the metal gate terminal. According to another aspect, the method further comprises forming a second semiconductor region in the semiconductor substrate body, the second semiconductor region having either a p-type doping or an n-type doping, such that if the gate metal is p-type then the second semiconductor region has the n-type doping, and if the gate metal is n-type then the second semiconductor region has the p-type doping, a portion of the second semiconductor region below a second side of the metal gate terminal. According to yet another aspect, the method further comprises forming a short trench isolation barrier in the semiconductor substrate body, a portion of the short trench isolation barrier below a second side of the metal gate terminal. According to yet another aspect, the gate metal is n-type and the gate metal comprises at least one of titanium aluminum nitride (TiAlN), titanium aluminide (TiAl), zirconium aluminide (ZrAl), and/or tungsten aluminide (WAl).

According to yet another aspect, a first gate breakdown voltage *V_{BDGSD}* at a boundary region between the metal gate terminal and the first semiconductor region is less than a second gate breakdown voltage *V_{BDGB}* at a boundary region between the metal gate terminal and the semiconductor substrate body. According to yet another aspect, the integrated circuit is an antifuse, and the gate dielectric is adapted to breakdown and create a conductive path between the metal gate terminal and the first semiconductor region if a programming voltage *V_{PP}* between the metal gate terminal and the first semiconductor region is equal to or exceeds a gate breakdown voltage *V_{BDGSD}.* According to one aspect, the method further comprises reducing the gate breakdown voltage *V_{BDGSD}* in proportion to a built-in electric field *E_{BIGSD}* associated with a boundary region between the metal gate terminal and the first semiconductor region.

Another feature provides an integrated circuit that comprises a metal gate terminal that includes a gate metal that is either p-type or n-type, a first semiconductor region having either a p-type doping or an n-type doping, such that if the gate metal is p-type then the first semiconductor region has the n-type doping, and if the gate metal is n-type then the first semiconductor region has the p-type doping, and a means for insulating the metal gate terminal from the first semiconductor region, the means for insulating interposed between the metal gate terminal and the first semiconductor region. According to one aspect, the integrated circuit is an antifuse, and the means for insulating is adapted to breakdown and create a means for conducting between the metal gate terminal and the first semiconductor region if a programming voltage *V_{PP}* between the metal gate terminal and the first semiconductor region is equal to or exceeds a gate breakdown voltage *V_{BDGSD}.* According to another aspect, a probability that the means for conducting forms at a boundary region between the metal gate terminal and the first semiconductor region is greater than a probability that the means for conducting forms at a boundary region between the metal gate terminal and a semiconductor substrate body below the gate dielectric. According to yet another aspect, the gate breakdown voltage *V_{BDGSD}* is reduced in proportion to a built-in electric field *E_{BIGSD}* associated with a boundary region between the metal gate terminal and the first semiconductor region.

### BRIEF DESCRIPTION OF THE DRAWINGS

FIG. 1 illustrates a typical IC gate oxide antifuse found in the prior art.
FIG. 2 illustrates a schematic, sectional view of an antifuse.
FIG. 3 illustrates a band diagram associated with the gate-source/drain boundary regions of an antifuse.
FIG. 4 illustrates a band diagram associated with the gate-body boundary region of an antifuse.
FIG. 5 illustrates a schematic, sectional view of a portion of an antifuse.
FIGS. 6 and 7 illustrate schematic, sectional views of antifuses.
FIG. 8 illustrates a band diagram associated with the gate-source/drain boundary regions of an antifuse.
FIG. 9 illustrates a band diagram associated with the gate-body boundary region of an antifuse.
FIG. 10 illustrates a schematic, sectional view of a portion of an antifuse.
FIG. 11 illustrates a schematic, sectional view of an antifuse
FIGS. 12 - 17 illustrate schematic, sectional views of progressive manufacturing stages/steps that form antifuses.
FIGS. 18 and 19 illustrate schematic diagrams of programmable memory cells that incorporate antifuses.
FIG. 20 illustrates a flowchart for a method of manufacturing an integrated circuit.
FIG. 21 illustrates various electronic devices that may include an integrated circuit.

### DETAILED DESCRIPTION

In the following description, specific details are given to provide a thorough understanding of the various aspects of the disclosure. However, it will be understood by one of ordinary skill in the art that the aspects may be practiced without these specific details. For example, circuits may be shown in block diagrams in order to avoid obscuring the aspects in unnecessary detail. In other instances, well-known circuits, structures and techniques may not be shown in detail in order not to obscure the aspects of the disclosure.

The word "exemplary" is used herein to mean "serving as an example, instance, or illustration." Any implementation or aspect described herein as "exemplary" is not necessarily to be construed as preferred or advantageous over other aspects of the disclosure. Likewise, the term "aspects" does not require that all aspects of the disclosure include the discussed feature, advantage or mode of operation. As used herein, the term "electrically coupled" is used herein to refer to the direct or indirect coupling between two objects that allows for the flow of electrical current to take place between the two objects. For example, if object A physically touches object B, and object B physically touches object C, then objects A and C may still be considered electrically coupled to one another-even if they do not directly physically touch each other-if object B is a conductor that allows for the flow of electrical current to take place from object A to object C and/or from object C to object A.

The terms wafer and substrate may be used herein to include any structure having an exposed surface with which to form an integrated circuit (IC) according to aspects of the present disclosure. The term substrate is understood to include semiconductor wafers. The term substrate is also used to refer to semiconductor structures during fabrication, and may include other layers that have been fabricated thereupon. The term substrate includes doped and undoped semiconductors, epitaxial semiconductor layers supported by a base semiconductor, or semiconductor layers supported by an insulator, as well as other semiconductor structures well known to one skilled in the art. The term insulator is defined to include any material that is less electrically conductive than materials generally referred to as conductors by those skilled in the art. The term "horizontal" is defined as a plane substantially parallel to the conventional plane or surface of a wafer or substrate, regardless of the orientation of the wafer or substrate. The term "vertical" refers to a direction substantially perpendicular to the horizontal as defined above. Prepositions, such as "on," "upper," "side," "higher," "lower," "over," and "under" when used with respect to the integrated circuits described herein are defined with respect to the conventional plane or surface being on the top surface of the wafer or substrate, regardless of the orientation of the wafer or substrate. The prepositions "on," "upper," "side," "higher," "lower," "over," and "under" are thereby defined with respect to "horizontal" and "vertical."

As used herein, the terms "source" and "drain" refer generally to the terminals or diffusion regions of a field effect transistor. A terminal or a diffusion region may be more specifically described as a "source" or a "drain" on the basis of a voltage applied to it when the field effect transistor is in operation. The term "source/drain" refers to either the source or the drain of the transistor.

As used herein, a semi-conductor, such as silicon, may be "p-type" or have a "p-type doping" if it has undergone a doping process that added acceptor atoms (one non-limiting example of which is Boron) in order to increase the number of free positive hole charge carriers. By contrast, a semi-conductor may be "n-type" or have a "n-type doping" if it has undergone a doping process that added donor atoms (one non-limiting example of which is Phosphorus) in order to increase the number of free negative electron charge carriers.

As used herein, a "metal gate" associated with a high-*K* metal gate process may comprise one or more metals and/or metal alloys. A metal alloy is any compound that is composed of one metal element and at least one other metal or nonmetal element. As used herein, a metal or a metal alloy is said to be "n-type" if it has a Fermi energy level *E_{F}* that is closer to the conduction band energy level *E_{C}* of a semiconductor (e.g., silicon, germanium, etc.) rather than the valence band energy level *E_{V}* of the semiconductor. Similarly, a metal or a metal alloy is said to be "p-type" if it has a Fermi energy level *E_{F}* that is closer to the valence band energy level *E_{V}* of a semiconductor (e.g., silicon, germanium, etc.) than the conduction band energy level *E_{C}* of the semiconductor.

### Antifuse

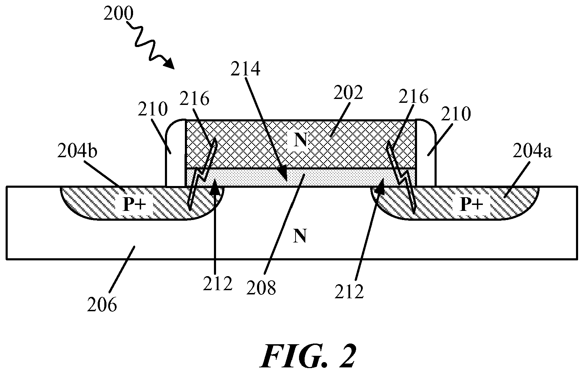

FIG. 2 illustrates a schematic, sectional view of an antifuse 200 according to one aspect of the present disclosure. The antifuse 200 (also referred to herein as a "transistor antifuse") comprises a metal gate terminal 202, source/drain terminals 204a, 204b (e.g., source/drain regions), a body terminal 206, a gate dielectric 208, and spacers 210. The antifuse 200 may be fabricated according to a high dielectric constant *K* and metal gate (HKMG) process.

As shown in FIG. 2, the first and second semiconductor regions 204a, 204b (i.e., source/drain regions) are p+-type doped regions that are deposited and/or otherwise disposed in the body 206. A portion of the first semiconductor region 204a is positioned below/underneath a first side of the metal gate terminal 202, and a portion of the second semiconductor region 204b is positioned below/underneath a second side of the metal gate terminal 202. The body 206 may be the bulk substrate of an integrated circuit die, or a well (or a series of embedded wells) within the bulk substrate.

According to one aspect, the gate dielectric 208 is substantially comprised of a dielectric material having a relatively high dielectric constant *K* as compared to silicon oxide (SiOₓ). The high-*K* gate dielectric 208 may reduce gate leakage current that is endemic of small scale (e.g., less than 45nm process) transistors having a standard silicon dioxide (SiO₂) gate oxide layer. In this fashion, the high-*K* gate dielectric 208 improves performance of the antifuse 200. According to one example, the gate dielectric 208 may have a dielectric constant *K* equal to or greater than ten (10). According to another example, the gate dielectric 208 may have a dielectric constant *K* equal to or greater than fifteen (15). According to yet another example, the gate dielectric 208 may have a dielectric constant *K* equal to or greater than twenty (20). The gate dielectric 208 may be comprised of such compounds as, but not limited to, hafnium oxide (HfO₂), hafnium silicon oxide (HfSiO), hafnium silicate (HfSiO₄), hafnium silicon oxynitride (HfSiON), aluminum oxide (Al₂O₃), lanthanum oxide (La₂O₃), lanthanum aluminum oxide (LaAlO), tantalum oxide (Ta₂O₃), zirconium oxide (ZrO₂), zirconium silicon oxide (ZrSiO), hafnium zirconium oxide (HfZrO), strontium bismuth tantalite (SrBi₂Ta₂O₉), lead zirconate titanate (PbZrₓTi₁₋ₓO₃), and/or barium strontium titanate (BaₓSr₁₋ₓTiO₃).

According to one aspect, the metal gate terminal 202 substantially includes one or more metals and/or metal alloys instead of polysilicon. As such, the metal gate terminal 202 offers superior conductivity compared to traditional polysilicon gates. In the illustrated example, the metal gate terminal 202 includes at least one gate metal that is n-type. For example, the n-type gate metal(s) comprising the metal gate terminal 202 may include, but is not limited to, titanium aluminum nitride (TiAlN), titanium aluminide (TiAl), zirconium aluminide (ZrAl), and/or tungsten aluminide (WAl).

As illustrated in FIG. 2, the antifuse 200 features a metal gate 202 and a body 206 that are n-type but source/drain regions 204a, 204b that are p+-type. The source/drain regions 204a, 204b are deposited in the body 206. Utilizing an HKMG process to fabricate the transistor antifuse 200 may allow for more flexibility in being able to form a transistor based antifuse 200 with a gate 202 and source/drain terminals 204a, 204b having opposite doping types. In non-HKMG processes, the gate and source/drain regions are typically doped at the same time by the manufacturing step that forms the source/drain regions, which results in a gate and source/drain regions that are the same doping type (e.g., both n-type or both p-type). HKMG processes allow the doping type of the gate and the source/drain regions to be uniquely selected without additional steps/costs.

As will be explained in greater detail below, antifuses 200, 600, 700, 1100 (See FIGS. 2, 6, 7, 11) that feature metal gate terminals and source/drain regions that have opposite types (e.g., n-type metal gates 202, 602 and p+-type source/drain regions 204a, 204b, 604a or p-type metal gates 702, 1102 and n+-type source/drain regions 704a, 704b, 1104a) cause a built-in electric field *E_{BIGSD}* to be present at the gate-source/drain boundary regions 212, 612, 712, 1112. This built-in electric field *E_{BIGSD}* is utilized to lower the breakdown voltage *V_{BDGSD}* (and thus the necessary programming voltage *V_{PP}*) of the gate dielectrics 208, 608, 708, 1108 at the gate-source/drain boundary regions 212, 612, 712, 1112 when the polarity of an external voltage supply (e.g., *V_{PP}*) is oriented in parallel (e.g., constructive addition) with the direction of *E_{BIGS}.* Moreover, since the gate dielectric breakdown voltage *V_{BD}* at the gate-source/drain boundary regions 212, 612, 712, 1112 is less than the gate dielectric breakdown voltage *V_{BD}* at the gate-body boundary regions 214, 614, 714, 1114 (due to *E_{BIGSD}* present at the gate-source/drain boundary regions 212, 612, 712, 1112), the antifuses' 200, 600, 700, 1100 gate dielectrics 208, 608, 708, 1108 may more consistently/predictably rupture at or near the gate-source/drain boundary regions 212, 612, 712, 1112 to form one or more conduction paths 216, 616, 716, 1116. This reduces the post-breakdown resistance value distribution and makes read operations more reliable.

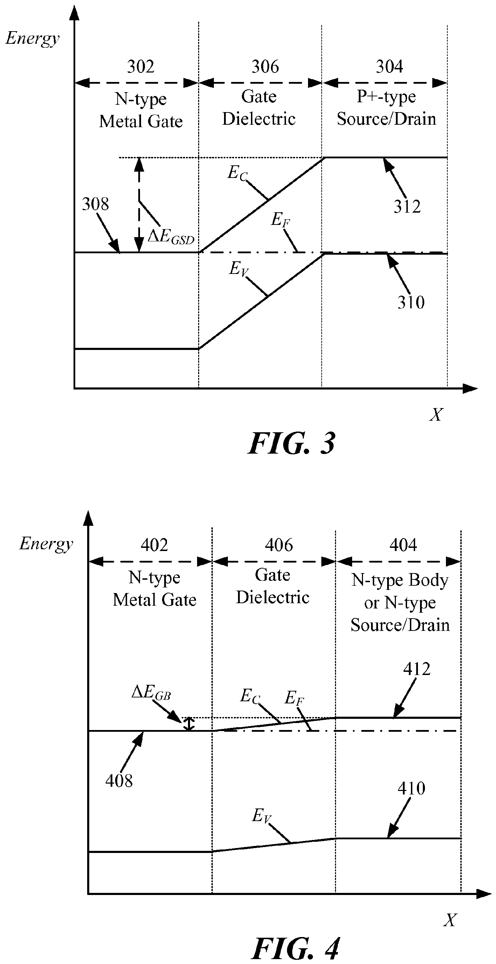

FIG. 3 illustrates a band diagram 300 associated with the gate-source/drain boundary regions 212 of the antifuse 200, while FIG. 4 illustrates a band diagram 400 associated with the gate-body boundary region 214 of the antifuse 200. The band diagrams 300, 400 have an Energy axis and a relative distance axis (labeled "X").

Referring to FIGS. 2 and 3, a first portion 302 of the band diagram 300 represents electron energy states of the n-type metal gate 202, and a second portion 304 represents electron energy states of any one of the p+-type source/drain regions 204a, 204b. The area 306 between the two portions 302, 304 is representative of the gate dielectric 208 in between the metal gate 202 and the source/drain regions 204a, 204b. The band diagram 300 is representative of electron energy states without an external voltage applied between the n-type metal gate 202 and the p+-type source/drain regions 204a, 204b. As shown, the n-type metal gate 202 has a Fermi energy level *E_{F}* that may be at or near its conduction band energy level (*E_{C}*) 308. The p+-type source/drain regions 204a, 204b have a Fermi energy level *E_{F}* that is closer to their valence band energy level (*E_{V}*) 310 than their conduction band energy level (*E_{C}*) 312. The energy level difference Δ*E_{GSD}* between the p+-type source/drain regions' conduction band energy level 312 and the n-type metal gate's conduction band energy level 308 is proportional to a built-in electric field *E_{BIGSD}* that intrinsically exists within the gate dielectric 208 between the n-type metal gate 202 and the p+-type source/drain regions 204a, 204b (i.e., within the gate dielectric 208 at the gate-source/drain boundary regions 212) when no external voltage is applied between the gate 202 and the source/drain 204a, 204b regions. As described below, this built-in electric field *E_{BIGSD}* is significantly greater than a small built-in electric field *E_{BIGB}* that may exist at the gate-body boundary region 214. Similarly, the built-in electric field *E_{BIGSD}* associated with the antifuse 200 having a metal gate 202 and source/drain regions 204a, 204b of opposite doping type (e.g., metal gate is n-type and source/drain is p+-type) is significantly greater than any small intrinsic electric field that may exist at a gate-source/drain boundary in a prior art antifuse, such as the antifuse 100 shown in FIG. 1, having a polysilicon gate and source/drain regions that are the same doping type (e.g., both gate and source/drain regions are n-type or both gate and source/drain regions are p-type).

Referring to FIGS. 2 and 4, a first portion 402 of the band diagram 400 represents electron energy states of the n-type metal gate 202, and a second portion 404 represents electron energy states of the n-type body 206. The area 406 between the two portions 402, 404 is representative of the gate dielectric 208 in between the metal gate 202 and the body 206. The band diagram 400 is representative of electron energy states without an external voltage applied between the n-type metal gate 202 and the n-type body 206. As shown, the n-type metal gate 202 has a Fermi energy level *E_{F}* that may be at or near its conduction band energy level (*E_{C}*) 408. The n-type body 206 may have a Fermi energy level *E_{F}* that is closer to its conduction band energy level (*E_{C}*) 412 than its valence band energy level (*E_{V}*) 410. The energy level difference Δ*E_{GB}* between the n-type body's conduction band energy level 412 and the n-type metal gate's conduction band energy level 408 is negligible (compared to *ΔE_{GSD}* of FIG. 3) since both the metal gate 202 and the body 206 are n-type. Thus, the built-in electric field *E_{BIGB},* which is proportional to Δ*E_{GB},* that may exist within the gate dielectric 208 at the gate-body boundary region 214 is significantly less than built-in electric field *E_{BIGSD}* that exists within the gate dielectric 208 at the gate-source/drain boundary regions 212. Similarly, prior art antifuse designs, such as the antifuse 100 shown in FIG.1, that feature a polysilicon gate terminal having the same doping type as a source or drain terminal (e.g., both n-type or both p-type) will also have a negligible energy level difference in their conduction bands similar to Δ*E_{GB}.* In the example shown, the n-type gate 202 and the n-type body 206 have slightly different conduction band energy levels 408, 412, however, in some cases these energy levels may be the same, and thus Δ*E_{GB}* approaches zero (0).

Referring to FIG. 2, generally, the antifuse's gate dielectric 208 is adapted to breakdown (e.g., form plasma channels) and create a conductive path between the metal gate terminal 202 and the source/drain regions 204a, 204b if a programming voltage *V_{PP}* between the metal gate terminal 202 and the source/drain regions 204a, 204b is equal to or exceeds a gate breakdown voltage *V_{BD}.* However, the gate breakdown voltage *V_{BD}* may vary along the length of the gate dielectric 208 (e.g., from one side of the gate dielectric 208 at the first semiconductor region 204a to the opposite side of the gate dielectric 208 at the second semiconductor region 204b) based on which built-in electric field (e.g., *E_{BIGSD}* or *E_{BIGB}*) is present at a particular portion of the gate dielectric's 208 length. For example, a first breakdown voltage *V_{BDGSD}* associated with the gate dielectric 208 at the gate-source/drain boundary regions 212 (e.g., gate-first semiconductor boundary region) is less than a second breakdown voltage *V_{BDGB}* associated with the gate dielectric 208 at the gate-body boundary region 214 since the built-in electric field *E_{BIGSD}* is significantly greater than the built-in electric field *E_{BIGB}.* Specifically, *V_{BDGSD}* is less than *V_{BDGB}* if the polarity of the external voltage supply (e.g., *V_{PP}*) is oriented in parallel with the direction of *E_{BIGSD}.* In this fashion, the gate breakdown voltage *V_{BDGSD}* is reduced in proportion to the built-in electric field *E_{BIGSD}* associated with the gate-source/drain boundary regions 212 between the metal gate terminal 202 and at least the first semiconductor region 204a.

Moreover, since *V_{BDGSD}* may be less than *V_{BDGB},* then the probability that a conductive path forms at the boundary region 212 between the metal gate terminal 202 and the first semiconductor region 204a is greater than a probability that a conductive path forms at the boundary region 214 between the metal gate terminal 202 and a semiconductor substrate body 206 below the gate dielectric 208. The probability that a conductive path forms at the boundary region 212 versus the boundary region 214 may be further compounded if during programming of the antifuse 200 the metal gate terminal 202 is at *V_{PP}*, the source/drain regions 204a, 204b are grounded, and the body terminal 206 is at a nominal supply voltage *V_{DD},* where *V_{PP}* ≥ *V_{BDGSD}* and *V_{PP}* - *V_{DD}* < *V_{TH}*.

According to one aspect, the probability that a conductive path forms at the boundary region 212 between the metal gate terminal 202 and the first semiconductor region 204a may be five (5) times greater than the probability that a conductive path forms at the boundary region 214 between the metal gate terminal 202 and a semiconductor substrate body 206. According to another aspect, the probability that a conductive path forms at the boundary region 212 between the metal gate terminal 202 and the first semiconductor region 204a may be ten (10) times greater than the probability that a conductive path forms at the boundary region 214 between the metal gate terminal 202 and a semiconductor substrate body 206. The increased probability that breakdowns will occur at the gate-source/drain boundary 212 helps reduce the post-breakdown resistance value distribution/range of the antifuse 200.

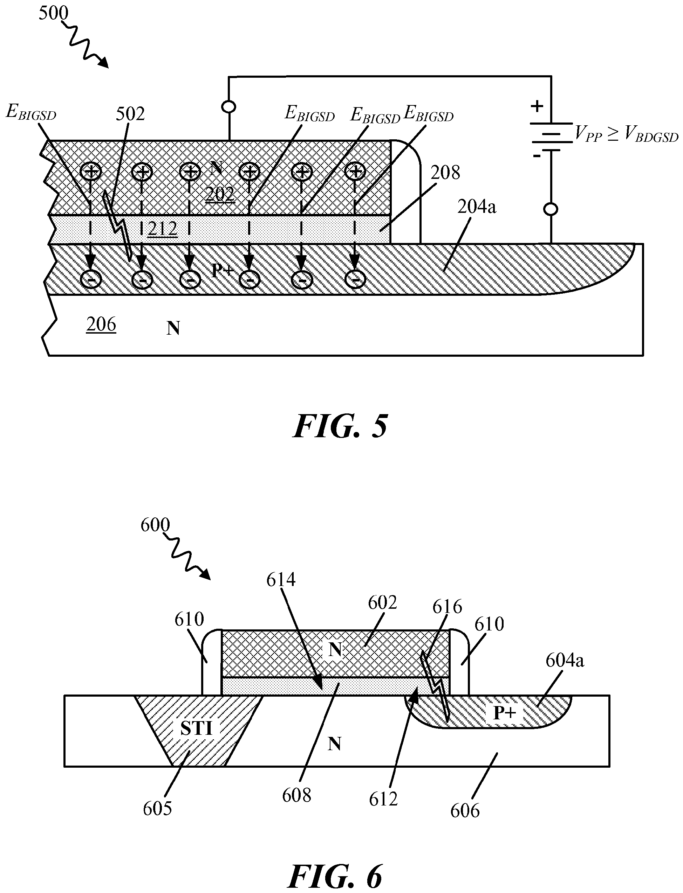

FIG. 5 illustrates a schematic, sectional view of a portion 500 of the antifuse 200 according to one aspect of the disclosure. Specifically, FIG. 5 illustrates a portion of the n-type metal gate 202 and the p+-type source/drain region 204a with a portion of the gate dielectric 208 interposed there between. As discussed above, the n-type metal gate 202 and the p+-type source/drain region 204a generate the built-in electric field *E_{BIGSD}* within the gate dielectric 208 at the gate-source/drain boundary regions 212. (For illustrative purposes, the built-in electric field *E_{BIGSD}* is shown as a plurality of dashed arrows originating from positive charge points to negative charge points.)

Notably, if a programming voltage *V_{PP}* with the proper voltage polarity relative to *E_{BIGSD}* is applied between the metal gate terminal 202 and the source/drain region 204a then the built-in electric field *E_{BIGSD}* helps reduce the programming voltage *V_{PP}* needed to program the antifuse 200. As shown in FIG. 5, the polarity of the programming voltage *V_{PP}* (where *V_{PP}* ≥ *V_{BDGSD}*) is oriented parallel to the built-in electric field *E_{BICSD}.* As a result the antifuse 200 may be programmed (e.g., change from an open circuit state to a closed circuit state). Moreover, the programming voltage *V_{PP}* required to exceed *V_{BDGSD}* may be reduced in proportion to *E_{BIGSD}*. Orienting the programming voltage *V_{PP}* in parallel to the built-in electric field *E_{BIGSD}* causes the electric field contributed by the external voltage source *V_{PP}* and the built-in electric field *E_{BIGSD}* to constructively add together thereby increasing the total electric field within the gate dielectric 208 at the gate-source/drain boundary regions 212. By contrast, if the polarity of the programming voltage *V_{PP}* is oriented opposite to the built-in electric field *E_{BIGSD}* such that the electric field contributed by the external voltage source *V_{PP}* and the built-in electric field *E_{BIGSD}* are destructively added together (i.e., subtracted from one another) then the total electric field within the gate dielectric 208 may decrease.

According to one example, programming the antifuse 200 creates a conductive path 502 between the metal gate terminal 202 and the first semiconductor region 204a at the gate-first semiconductor boundary region 212. Depending on the type of dielectric chosen for the gate dielectric 208, formation of the conductive path may be irreversible and permanently program the antifuse 200, which is desirable when used in OTP memory cells. For example, the gate dielectric 208 may comprise at least one of hafnium oxide (HfO₂), hafnium silicon oxide (HfSiO), and/or hafnium silicate (HfSiO₄). The same principles and modes of operation discussed herein for the first source/drain terminal 204a equally apply to the second source/drain terminal 204b.

FIG. 6 illustrates a schematic, sectional view of an antifuse 600 according to one aspect of the present disclosure. The antifuse 600 comprises an n-type metal gate terminal 602, a p+-type first semiconductor region 604a, an n-type body 606, a gate dielectric 608, and spacers 610. The antifuse 600 is substantially similar to the antifuse 200 shown in FIG. 2, except that it does not have a second semiconductor region 204b. Instead, underneath/below the second side of the metal gate terminal 602 lies a short trench isolation (STI) region 605 that is deposited and/or otherwise disposed into the well/substrate body region 606. The STI region 605 may be comprised of a dielectric material, such as silicon dioxide and serves as a barrier against leakage currents between adjacent semiconductor device components.

Characteristics and operation of the antifuse 600 are substantially similar to the antifuse 200 described above with respect to FIGS. 2 - 5. For example, a built-in electric field *E_{BIGSD}* also exists within the gate dielectric 608 between the n-type metal gate 602 and the p+-type first semiconductor region 604a in the same fashion described above with respect to the antifuse 200. As such, a programming voltage *V_{PP}* ≥ *V_{BDGSD}* applied with a polarity oriented in parallel with the built-in electric field *E_{BIGSD}* will break down the gate dielectric 608 at the gate-first semiconductor region boundary 612 to form a conduction path 616 between the metal gate 602 and the first semiconductor region 604a. Similar to the antifuse 200, since the metal gate 602 and the body 606 are both n-type, the breakdown voltage *V_{BDGB}* at the gate-body boundary region 614 may be higher than the breakdown voltage *V_{BDGSD}* at the gate-first semiconductor boundary region 612 since the built-in electric field *E_{BIGSD}* is significantly greater than *E_{BIGB}.* This difference in breakdown voltages helps reduce the post-breakdown resistance value distribution/range of the antifuse 600 since it increases the probability that breakdowns and conduction paths will form at the gate-first semiconductor region 612.

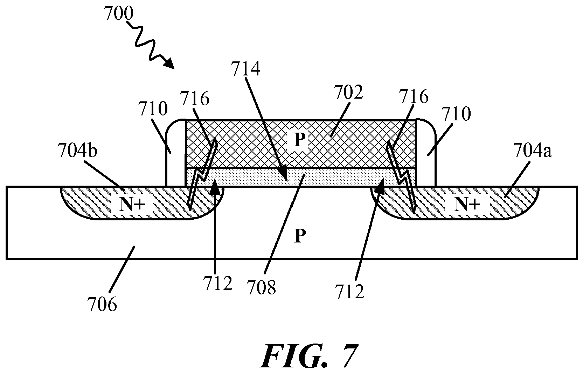

FIG. 7 illustrates a schematic, sectional view of an antifuse 700 according to one aspect of the present disclosure. The antifuse 700 (also referred to herein as a "transistor antifuse") comprises a metal gate terminal 702, source/drain terminals 704a, 704b (e.g., source/drain regions), a body terminal 706, a gate dielectric 708, and spacers 710. The antifuse 700 may be fabricated according to a high dielectric constant K and metal gate (HKMG) process.

As shown in FIG. 7, the first and second semiconductor regions 704a, 704b (i.e., source/drain regions) are n+-type doped regions that are deposited and/or otherwise disposed in the body 706. A portion of the first semiconductor region 704a is positioned below/underneath a first side of the metal gate terminal 702, and a portion of the second semiconductor region 704b is positioned below/underneath a second side of the metal gate terminal 702. The body 706 may be the bulk substrate of an integrated circuit die, or a well (or a series of embedded wells) within the bulk substrate.

According to one aspect, the gate dielectric 708 is substantially comprised of a dielectric material having a relatively high dielectric constant *K* as compared to silicon oxide (SiOₓ). The high-*K* gate dielectric 708 may reduce gate leakage current that is endemic of small scale (e.g., less than 45nm process) transistors having a standard silicon dioxide (SiO₂) gate oxide layer. In this fashion, the high-*K* gate dielectric 708 improves performance of the antifuse 700. According to one example, the gate dielectric 708 may have a dielectric constant *K* equal to or greater than ten (10). According to another example, the gate dielectric 708 may have a dielectric constant *K* equal to or greater than fifteen (15). According to yet another example, the gate dielectric 708 may have a dielectric constant *K* equal to or greater than twenty (20). The gate dielectric 708 may be comprised of any one of the same compounds described above with respect to the gate dielectric 208.

According to one aspect, the metal gate terminal 702 substantially includes one or more metals and/or metal alloys instead of polysilicon. As such, the metal gate terminal 702 offers superior conductivity compared to traditional polysilicon gates. In the illustrated example, the metal gate terminal 702 includes at least one gate metal that is p-type. For example, the p-type gate metal(s) comprising the metal gate terminal 702 may include, but is not limited to, titanium nitride (TiN) and/or titanium carbide (TiC).

As illustrated in FIG. 7, the antifuse 700 features a metal gate 702 and a body 706 that are p-type but source/drain regions 704a, 704b that are n+-type. The source/drain regions 704a, 704b are deposited and/or otherwise disposed in the body 706. Utilizing an HKMG process to fabricate the transistor antifuse 700 may allow for more flexibility in being able to form a transistor based antifuse 700 with a gate 702 and source/drain terminals 704a, 704b having opposite doping types.

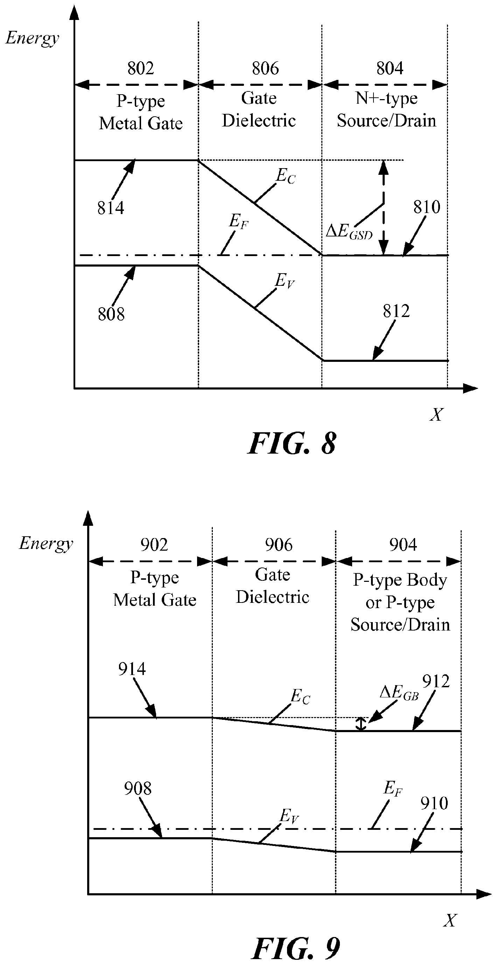

FIG. 8 illustrates a band diagram 800 associated with the gate-source/drain boundary regions 712 of the antifuse 700, while FIG. 9 illustrates a band diagram 900 associated with the gate-body boundary region 714 of the antifuse 700. The band diagrams 800, 900 have an Energy axis and a relative distance axis (labeled "X").

Referring to FIGS. 7 and 8, a first portion 802 of the band diagram 800 represents electron energy states of the p-type metal gate 702, and a second portion 804 represents electron energy states of any one of the n+-type source/drain regions 704a, 704b. The area 806 between the two portions 802, 804 is representative of the gate dielectric 708 in between the metal gate 702 and the source/drain regions 704a, 704b. The band diagram 800 is representative of electron energy states without an external voltage applied between the p-type metal gate 702 and the n+-type source/drain regions 704a, 704b. As shown, the p-type metal gate 702 has a Fermi energy level *E_{F}* that may be at or near its valence band energy level (*E_{V}*) 808. The n+-type source/drain regions 704a, 704b have a Fermi energy level *E_{F}* that is at or close to their conduction band energy level (*E_{C}*) 810 than their valence band energy level (*E_{V}*) 812. The energy level difference Δ*E_{GSD}* between the p-type metal gate's conduction band energy level (*E_{C}*) 814and the n+-type source/drain regions' conduction band energy level 810 is proportional to a built-in electric field *E_{BIGSD}* that intrinsically exists within the gate dielectric 708 between the p-type metal gate 702 and the n+-type source/drain regions 704a, 704b (i.e., within the gate dielectric 708 at the gate-source/drain boundary regions 712) when no external voltage is applied between the gate 702 and the source/drain 704a, 704b regions. As described below, this built-in electric field *E_{BIGSD}* is significantly greater than a small built-in electric field *E_{BIGB}* that may exist at the gate-body boundary region 714. Similarly, the built-in electric field *E_{BIGSD}* associated with the antifuse 700 having a metal gate 702 and source/drain regions 704a, 704b of opposite doping type (e.g., metal gate is p-type and source/drain is n+-type) is significantly greater than any small intrinsic electric field that may exist at a gate-source boundary in a prior art antifuse, such as the antifuse 100 shown in FIG. 1, having a polysilicon gate and source/drain regions that are the same doping type (e.g., both n-type or both p-type).

Referring to FIGS. 7 and 9, a first portion 902 of the band diagram 900 represents electron energy states of the p-type metal gate 702, and a second portion 904 represents electron energy states of the p-type body 706. The area 906 between the two portions 902, 904 is representative of the gate dielectric 708 in between the metal gate 702 and the body 706. The band diagram 900 is representative of electron energy states without an external voltage applied between the p-type metal gate 702 and the p-type body 706. As shown, the p-type metal gate 702 has a Fermi energy level *E_{F}* that may be at or near its valence band energy level (*E_{V}*) 908. The p-type body 706 may have a Fermi energy level *E_{F}* that is also closer to its valence band energy level (*E_{V}*) 910 than its conduction band energy level (*E_{C}*) 912. The energy level difference Δ*E_{GB}* between the p-type metal gate's conduction band energy level (*E_{C}*) 914 and the p-type body's conduction band energy level (*E_{C}*) 912 is negligible (compared to Δ*E_{GSD}* of FIG. 8) since both the metal gate 702 and the body 706 are p-type. Thus, the built-in electric field *E_{BIGB},* which is proportional to Δ*E_{GB},* that may exist within the gate dielectric 708 at the gate-body boundary region 714 is significantly less than built-in electric field *E_{BIGSD}* that exists within the gate dielectric 708 at the gate-source/drain boundary regions 712. Similarly, prior art antifuse designs, such as the antifuse 100, that feature a polysilicon gate terminal having the same doping type as a source or drain terminal (e.g., both n-type or both p-type) will also have a negligible energy level difference in their conduction bands similar to Δ*E_{GB}.* In the example shown, the p-type gate 702 and the p-type body 706 have slightly different conduction band energy levels 908, 912, however, in some cases these energy levels may be the same, and thus Δ*E_{GB}* approaches zero (0).

Referring to FIG. 7, generally, the antifuse's gate dielectric 708 is adapted to breakdown and create a conductive path between the metal gate terminal 702 and the source/drain regions 704a, 704b if a programming voltage *V_{PP}* between the metal gate terminal 702 and the source/drain regions 704a, 704b is equal to or exceeds a gate breakdown voltage *V_{BD}.* However, the gate breakdown voltage *V_{BD}* may vary along the length of the gate dielectric 708 (e.g., from one side of the gate dielectric 708 at the first semiconductor region 704a to the opposite side of the gate dielectric 708 at the second semiconductor region 704b) based on which built-in electric field (e.g., *E_{BIGSD}* or *E_{BIGB}*) is present at a particular portion of the gate dielectric's 708 length. For example, a first breakdown voltage *V_{BDGSD}* associated with the gate dielectric 708 at the gate-source/drain boundary regions 712 (e.g., gate-first semiconductor boundary region) is less than a second breakdown voltage *V_{BDGB}* associated with the gate dielectric 708 at the gate-body boundary region 714 since the built-in electric field *E_{BIGSD}* is significantly greater than the built-in electric field *E_{BIGB}.* Specifically, *V_{BDGSD}* is less than *V_{BDGB}* if the polarity of the external voltage supply (e.g., *V_{PP}*) is oriented in parallel with the direction of *E_{BIGSD}.* In this fashion, the gate breakdown voltage *V_{BDGSD}* is reduced in proportion to the built-in electric field *E_{BIGSD}* associated with the gate-source/drain boundary regions 712 between the metal gate terminal 702 and at least the first semiconductor region 704a.

Moreover, since *V_{BDGSD}* may be less than *V_{BDGB},* then the probability that a conductive path forms at the boundary region 712 between the metal gate terminal 702 and the first semiconductor region 704a is greater than a probability that a conductive path forms at the boundary region 714 between the metal gate terminal 702 and a semiconductor substrate body 706 below the gate dielectric 708. The probability that a conductive path forms at the boundary region 712 versus the boundary region 714 may be further compounded if during programming of the antifuse 700 the metal gate terminal 702 is grounded, the source/drain regions 704a, 704b are at *V_{PP},* and the body terminal 706 is also grounded, where *V_{PP}* ≥ *V_{BDCSD}.*

According to one aspect, the probability that a conductive path forms at the boundary region 712 between the metal gate terminal 702 and the first semiconductor region 704a may be five (5) times greater than the probability that a conductive path forms at the boundary region 714 between the metal gate terminal 702 and a semiconductor substrate body 706. According to another aspect, the probability that a conductive path forms at the boundary region 712 between the metal gate terminal 702 and the first semiconductor region 704a may be ten (10) times greater than the probability that a conductive path forms at the boundary region 714 between the metal gate terminal 702 and a semiconductor substrate body 706. The increased probability that breakdowns will occur at the gate-source/drain boundary 712 helps reduce the post-breakdown resistance value distribution/range of the antifuse 700.

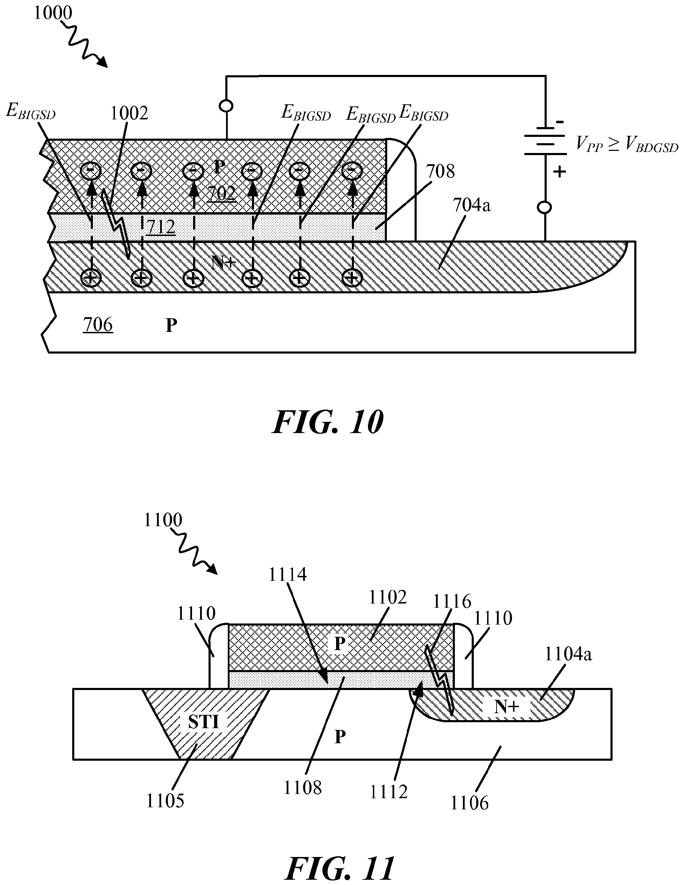

FIG. 10 illustrates a schematic, sectional view of a portion 1000 of the antifuse 700 according to one aspect of the disclosure. Specifically, FIG. 10 illustrates a portion of the p-type metal gate 702 and the n+-type source/drain region 704a with a portion of the gate dielectric 708 interposed there between. As discussed above, the p-type metal gate 702 and the n+-type source/drain region 704a generate the built-in electric field *E_{BIGSD}* within the gate dielectric 708 at the gate-source/drain boundary regions 712. (For illustrative purposes, the built-in electric field *E_{BIGSD}* is shown as a plurality of dashed arrows originating from positive charge points to negative charge points.)

Notably, if a programming voltage *V_{PP}* with the proper voltage polarity relative to *E_{BIGSD}* is applied between the metal gate terminal 702 and the source/drain region 704a then the built-in electric field *E_{BIGSD}* helps reduce the programming voltage *V_{PP}* needed to program the antifuse 700. As shown in FIG. 10, the polarity of the programming voltage *V_{PP}* (where *V_{PP}* ≥ *V_{BDGSD}*) is oriented parallel to the built-in electric field *E_{BIGSD}.* As a result the antifuse 700 may be programmed (e.g., change from an open circuit state to a closed circuit state). Moreover, the programming voltage *V_{PP}* required to exceed *V_{BDGSD}* may be reduced in proportion to *E_{BIGSD}*. Orienting the programming voltage *V_{PP}* in parallel to the built-in electric field *E_{BIGSD}* causes the electric field contributed by the external voltage source *V_{PP}* and the built-in electric field *E_{BIGSD}* to constructively add together thereby increasing the total electric field within the gate dielectric 708 at the gate-source/drain boundary regions 712. By contrast, if the polarity of the programming voltage *V_{PP}* is oriented opposite to the built-in electric field *E_{BIGSD}* such that the electric field contributed by the external voltage source *V_{PP}* and the built-in electric field *E_{BIGSD}* are destructively added together (i.e., subtracted from one another) then the total electric field within the gate dielectric 708 may decrease.

According to one example, programming the antifuse 700 creates a conductive path 1002 between the metal gate terminal 702 and the first semiconductor region 704a at the gate-first semiconductor boundary region 712. Depending on the type of dielectric chosen for the gate dielectric 708, formation of the conductive path may be irreversible and permanently program the antifuse 700, which is desirable when used in OTP memory cells. For example, the gate dielectric 708 may comprise at least one of hafnium oxide (HfO₂), hafnium silicon oxide (HfSiO), and/or hafnium silicate (HfSiO₄). The same principles and modes of operation discussed herein for the first source/drain terminal 704a equally apply to the second source/drain terminal 704b.

FIG. 11 illustrates a schematic, sectional view of an antifuse 1100 according to one aspect of the present disclosure. The antifuse 1100 comprises a p-type metal gate terminal 1102, an n+-type first semiconductor region 1104a, a p-type body 1106, a gate dielectric 1108, and spacers 1110. The antifuse 1100 is substantially similar to the antifuse 700 shown in FIG. 7, except that it does not have a second semiconductor region 704b. Instead, underneath/below the second side of the metal gate terminal 1102 lies a short trench isolation (STI) region 1105 that is deposited and/or otherwise disposed into the well/substrate body region 1106. The STI region 1105 may be comprised of a dielectric material, such as silicon dioxide and serves as a barrier against leakage currents between adjacent semiconductor device components.

Characteristics and operation of the antifuse 1100 are substantially similar to the antifuse 700 described above with respect to FIGS. 7 - 10. For example, a built-in electric field *E_{BIGSD}* also exists within the gate dielectric 1108 between the p-type metal gate 1102 and the n+-type first semiconductor region 1104a in the same fashion described above with respect to the antifuse 700. As such, a programming voltage *V_{PP}* ≥ *V_{BDGSD}* applied with a polarity oriented in parallel with the built-in electric field *E_{BIGSD}* will break down the gate dielectric 1108 at the gate-first semiconductor region boundary 1112 to form a conduction path 1116 between the metal gate 1102 and the first semiconductor region 1104a. Similar to the antifuse 700, since the metal gate 1102 and the body 1106 are both p-type, the breakdown voltage *V_{BDGB}* at the gate-body boundary region 1114 may be higher than the breakdown voltage *V_{BDGSD}* at the gate-first semiconductor boundary region 1112 since a built-in electric field *E_{BIGSD}* is significantly greater than *E_{BIGB}.* This difference in breakdown voltages helps reduce the post-breakdown resistance value distribution/range of the antifuse 1100 since it increases the probability that breakdowns and conduction paths will form at the gate-first semiconductor region 1112.

According to one aspect, the antifuses 200, 600, 700, 1100 may be used in a one-time programmable memory cell where a conduction path formed through the gate dielectric 208, 608, 708, 1108 is irreversible. According to another aspect, the antifuses 200, 600, 700, 1100 may be used in a multi-time programmable (MTP) memory cell where a conduction path formed through the gate dielectric 208, 608, 708, 1108 is reversible.

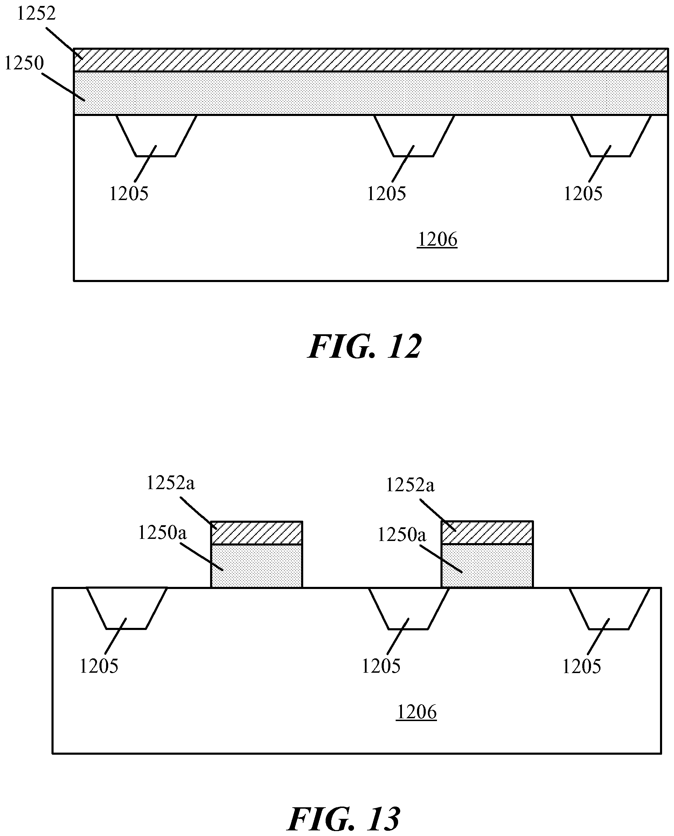

FIGS. 12 - 17 illustrate schematic, sectional views of progressive manufacturing stages/steps that form the antifuses 200, 600, 700, 1100 according to one aspect. The below manufacturing process is merely one example of how to fabricate the antifuses 200, 600, 700, 1100 and other manufacturing steps/stages may be performed instead of or in conjunction with the steps/stages described below.

FIG. 12 begins by illustrating an intermediate manufacturing stage of the antifuses 200, 600, 700, 1100 according to one example. First, a semiconductor substrate or a well within a substrate, such as silicon and/or germanium, is provided to serve as the semiconductor body 1206. The body 1206 may be doped so that it is n-type if a p-type channel antifuse 200, 600 is to be fabricated. Alternatively, the body 1206 may be doped so that it is p-type if an n-type channel antifuse 700, 1100 is to be fabricated. The body 1206 may be a silicon-on-insulator (SOI) or other semiconductor-on-insulator substrate. The body 1206 may include STI regions 1205 formed therein. For example, the STI regions 1205 may be formed by etching or otherwise forming a recess in the body 1206, and subsequently filling the recess with silicon dioxide, possibly followed by a chemical-mechanical-polishing (CMP) step. Next, a thin oxide layer (not shown) may be formed over the body 1206 by thermal oxidation of the semiconductor body 1206. The thin oxide layer (not shown) may be comprised of silicon dioxide, silicon oxynitride, and/or other materials. Next, a polysilicon layer 1250 may be formed on top of the thin oxide layer (not shown). The polysilicon layer 1250 may be formed by one or more chemical vapor deposition (CVD) processes, and/or other deposition processes. A capping layer 1252 may be then be formed on top the polysilicon layer 1250. The capping layer 1252 may comprise silicon nitride and may also be formed by a CVD process.

FIG. 13 illustrates a subsequent manufacturing stage of the antifuses 200, 600, 700, 1100 according to one aspect. At this stage the capping layer 1252 has been patterned to form caps 1252a, and the polysilicon layer 1250 has been patterned to form dummy gates 1250a. According to just one example, the capping layer 1252 and the polysilicon layer 1250 may be patterned by two or more etching processes, including one or more first etching processes employed to pattern the capping layer 1252 to form caps 1252a. One or more subsequent etching processes that employ the caps 1252a may be used to pattern the polysilicon layer 1250 underneath to form the dummy gates 1250a. These etching processes may include dry etching, wet etching, reactive-ion-etching (RIE), etc. The etching processes may also remove portions of the thin oxide layer (not shown), thereby exposing portions of the semiconductor body 1206 between the dummy gates 1250a.

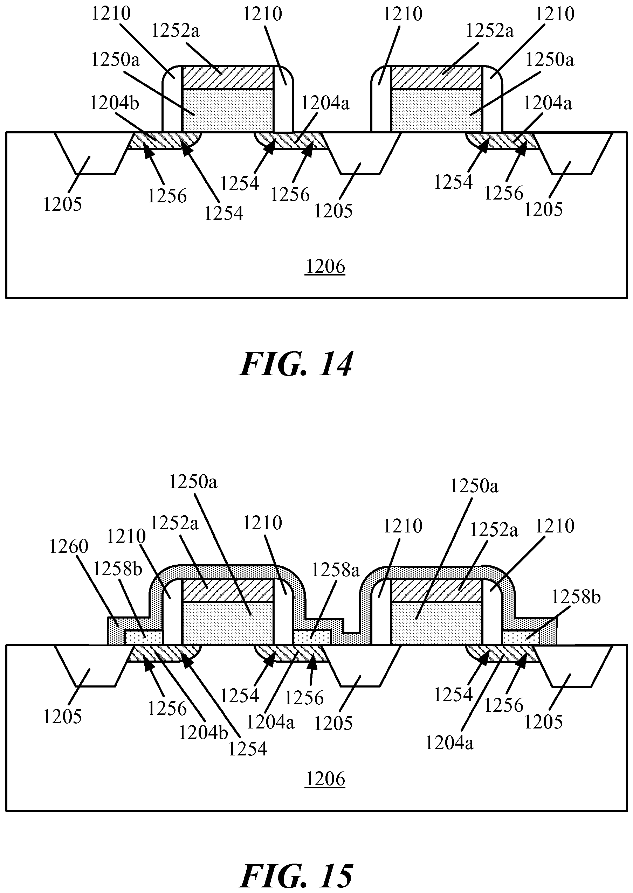

FIG. 14 illustrates a subsequent manufacturing stage of the antifuses 200, 600, 700, 1100 according to one aspect. At this stage source/drain regions (i.e., semiconductor regions) 1204a, 1204b are formed in the body 1206 on opposing sides of the dummy gates 1250a. The source/drain regions 1204a, 1204b may be formed by implanting ions into the substrate, followed by an appropriate annealing process. The ions implanted into the source/drain regions 1204a, 1204b may be such that they cause the source/drain regions 1204a, 1204b to be generally p-type if a p-type channel antifuse 200, 600 is to be fabricated, or n-type if an n-type channel antifuse 700, 1100 is to be fabricated. Moreover, spacers 1210 comprising one or more layers of silicon nitride may be conventionally formed or deposited spanning the sidewalls of the dummy gates 1250a and caps 1252a. According to one example, the source/drain regions 1204a, 1204b may include lightly doped portions 1254 (e.g., n-type or p-type) directly underneath the dummy gates 1250a and the spacers 1210, and heavily doped portions (e.g., n+-type or p+-type) 1256 outside the spacers 1210.

FIG. 15 illustrates a subsequent manufacturing stage of the antifuses 200, 600, 700, 1100 according to one aspect. At this stage contacts 1258a, 1258b (e.g., silicide contacts) are formed on the heavily doped source/drain regions 1256, and an etch stop layer 1260 is subsequently formed over the silicide contacts 1258a, 1258b, the spacers 1210, and the caps 1252a. The etch stop layer 1260 may be conventionally formed, and may comprise silicon dioxide, hafnium dioxide, carbon-doped silicon oxide, and/or other materials.

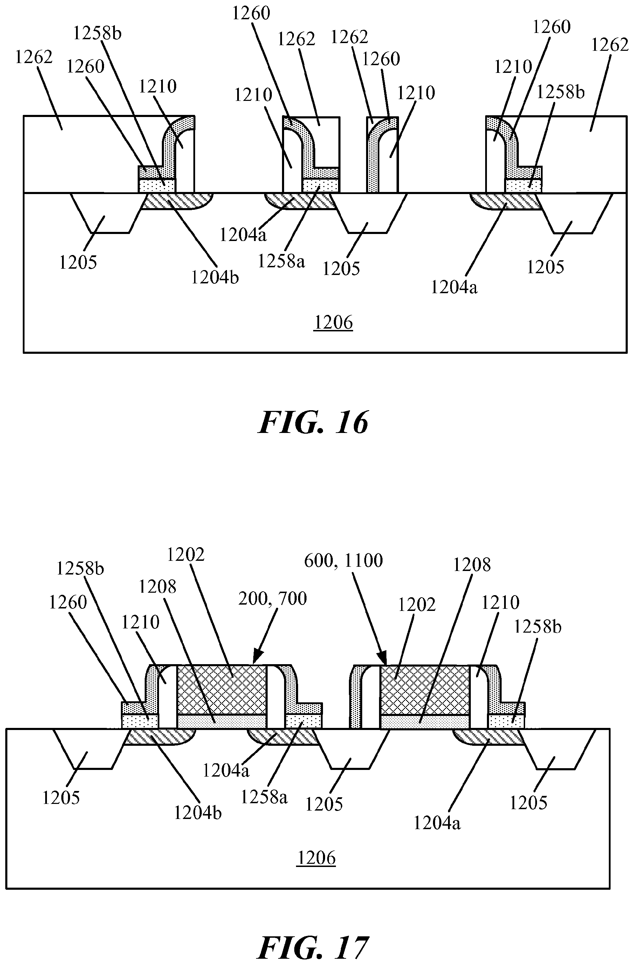

FIG. 16 illustrates a subsequent manufacturing stage of the antifuses 200, 600, 700, 1100 according to one aspect. At this stage a thick dielectric layer 1262 may be formed over the etch stop layer 1260 and subsequently planarized using the etch stop layer 1260 as a stopping point. Thereafter, the dummy gates 1250a, the caps 1252a, and portions of the etch stop layer 1260 between the spacers 1210 are removed, thereby forming cavities corresponding to where the dummy gates 1250a used to be. Moreover, a portion of the etch stop layer 1260 next to the silicide contact 1258a may also be removed exposing the STI 1205 underneath. The thick dielectric layer 1262 may be conventionally formed, and may include silicon dioxide.

FIG. 17 illustrates a subsequent manufacturing stage of the antifuses 200, 600, 700, 1100 according to one aspect. At this stage a high-*K* dielectric layer is formed within the cavities over the semiconductor body 1206 (more specifically over the thin oxide layer (not shown) just above the semiconductor body 1206). The high-*K* dielectric layer may include any of the aforementioned high-*K* dielectric materials. Next, a metal layer is deposited over the high-*K* dielectric layer. The specific metal(s) comprising the metal layer depends on whether the semiconductor regions 1204a, 1204b are generally n-type or p-type. One or more n-type metals (e.g., titanium aluminum nitride (TiAlN)) may be used for the metal layer if the semiconductor regions 1204a, 1204b are generally p-type, and one or more p-type metals (e.g., titanium nitride TiN) may be used for the metal layer if the semiconductor regions 1204a, 1204b are generally n-type. Next, portions of the high-*K* dielectric layer and the metal layer may then be planarized to form the gate dielectrics 1208 and the metal gates 1202. The thick dielectric layer 1262 may also be removed. In this fashion, the antifuses 200, 600, 700, 1100 may be formed according to one example.

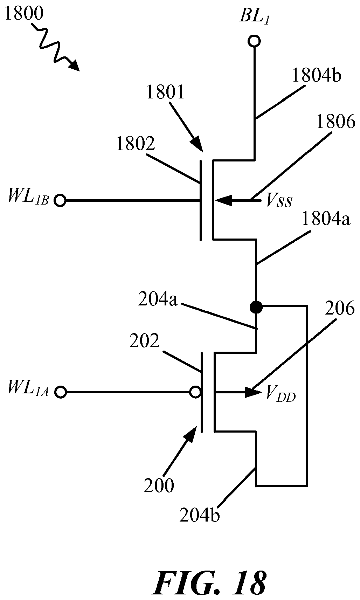

FIG. 18 illustrates a schematic diagram of a programmable memory cell 1800 that incorporates the antifuse 200 according to one aspect of the present disclosure. According to one example, the memory cell 1800 may be an OTP memory cell. The memory cell 1800 comprises a passgate transistor 1801 and the antifuse 200. The metal gate 202 of the antifuse 200 may be electrically coupled to a first word line (*WL_{1A}*), the antifuse's source/drain terminals 204a, 204b may be electrically coupled to a first source/drain terminal 1804a of the passgate transistor, and the antifuse's body terminal 206 may be electrically coupled to a nominal supply voltage *V_{DD}.* The passgate transistor's gate 1802 may be electrically coupled to a second word line (*WL_{1B}*)*,* a second source/drain terminal 1804b of the passgate transistor 1801 may be electrically coupled to a bit line (*BL₁*), and a body terminal 1806 may be electrically coupled to ground (shown as *V_{SS}*). "Read" (i.e., sensing the logical value stored) and "write" (i.e., programming the memory cell 1800) operations of the memory cell 1800 may be controlled by voltages applied to the first and second word lines *WL_{1A}* and *WL_{1B}* and the bit line B*L₁*.

According to one example, the memory cell 1800 may be written to (i.e., programmed) in the following manner. The second word line *WL_{1B}* and the passgate transistor's gate 1802 may be electrically coupled to the nominal supply voltage *V_{DD}* thereby turning on (i.e., making conductive) the passgate transistor 1801 (e.g., where the supply voltage *V_{DD}* is greater than the transistor's 1801 threshold voltage *V_{TH}*). The bit line *BL₁* and the passgate transistor's second source/drain terminal 1804b may be electrically coupled to ground *V_{SS}*. Since the passgate transistor 1801 is conductive, the source/drain terminals 204a, 204b are also at ground *V_{SS}.* The first word line *WL_{1A}* and the antifuse's gate terminal 202 may be electrically coupled to a programming voltage *Vpp* that is equal to or greater than the gate dielectric breakdown voltage *V_{BD}* (e.g., *V_{BDGSD}*) of the antifuse 200. The voltage potential (*V_{PP}*) across the gate terminal 202 and the source/drain terminals 204a, 204b of the antifuse 200 causes the gate dielectric 208 of the antifuse 202 to break down (i.e., antifuse 200 transitions from open circuit state to closed circuit state) and creates a short circuit path between the first word line *WL_{1A}* and the bit line B*L₁*. Thus, a current will flow from the higher potential (e.g., *Vpp)* first word line *WL_{1A}* through the antifuse's metal gate terminal 202, through one or more of the antifuse's source/drain terminals 204a and/or 204b, and through the passgate transistor's source/drain terminals 1804a, 1804b to the lower potential (e.g., ground *V_{SS}*) bit line *BL₁*. The closed circuit state of the antifuse 200 may correspond to one logical value (e.g., a "one") whereas the open circuit state may correspond to another logical value (e.g., a "zero").

According to one example, the memory cell 1800 may be read in the following manner. The second word line *WL_{1B}* and the passgate transistor's gate 1802 may be electrically coupled to the nominal supply voltage *V_{DD}* thereby turning on (i.e., making conductive) the passgate transistor 1801 (e.g., where the supply voltage *V_{DD}* is greater than the transistor's 1801 threshold voltage *V_{TH}*). The bit line *BL₁* and the passgate transistor's second source/drain terminal 1804b may be electrically coupled to a read voltage *V_{RD}* which may be, for example, *V_{DD}.* Since the passgate transistor 1801 is conductive, the source/drain terminals 204a, 204b are also at the read voltage *V_{RD}.* The first word line *WL_{1A}* and the antifuse's gate terminal 202 may be electrically coupled to ground *V_{SS}*. As such, the antifuse's source/drain terminals 204a, 204b may be at a higher voltage potential (*V_{RD}*) than the gate terminal 202, and consequently, the polarity of the read voltage *V_{RD}* is oriented opposite to the built-in electric field *E_{BIGSD}*.

If the antifuse 200 has been previously programmed such that the antifuse 200 is in a closed circuit state (i.e., the gate dielectric has been broken down), then a significant amount of current will flow from the bit line *BL₁* through the passgate transistor's source/drain terminals 1804a, 1804b, through one or more of the antifuse's source/drain terminals 204a, 204b, and through the antifuse's metal gate terminal 202 to the first word line *WL_{1A}.* However, if the antifuse 200 has not been previously programmed and is still in an open state (i.e., the gate dielectric has not been broken down), then a negligible leakage current may flow from the bit line *BL₁* through the passgate transistor's source/drain terminals 1804a, 1804b, through one or more of the antifuse's source/drain terminals 204a, 204b, and through the antifuse's metal gate terminal 202 to the first word line *WL_{1A}.* Sensing circuitry electrically coupled to the bit line *BL₁* detects the amount of current flow, and based on whether it is significant or negligible, it may determine the logical state of the antifuse 200.

In one aspect, *V_{PP}* is greater than or equal to *V_{DD}.* According to another aspect, *Vpp* may be equal to the highest input/output (I/O) voltage available on the IC having the memory cell 1800. According to yet another aspect, the antifuse 200 may be permanently programmed such that antifuse 200 cannot revert back to an open circuit state once closed.

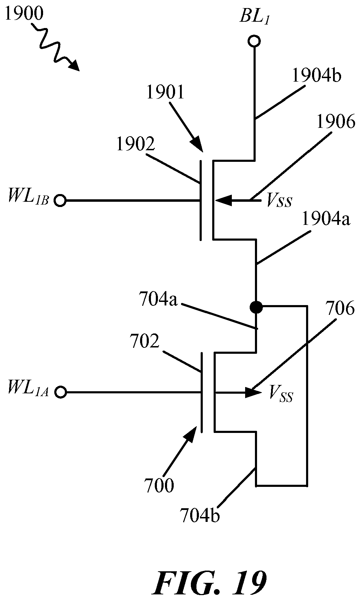

FIG. 19 illustrates a schematic diagram of a programmable memory cell 1900 that incorporates the antifuse 700 according to one aspect of the present disclosure. According to one example, the memory cell 1900 may be an OTP memory cell. The memory cell 1900 comprises a passgate transistor 1901 and the antifuse 700. The metal gate 702 of the antifuse 700 may be electrically coupled to a first word line (*WL_{1A}*), the antifuse's source/drain terminals 704a, 704b may be electrically coupled to a first source/drain terminal 1904a of the passgate transistor, and the antifuse's body terminal 706 may be electrically coupled to ground *V_{SS}*. The passgate transistor's gate 1902 may be electrically coupled to a second word line (*WL_{1B}*), the passgate transistor's second source/drain terminal 1904b may be electrically coupled to a bit line (*BL₁*), and the passgate transistor's body terminal 1906 may be electrically coupled to ground *V_{SS}*. Read and write operations of the memory cell 1900 may be controlled by voltages applied to the first and second word lines *WL_{1A}* and *WL_{1B}* and the bit line B*L₁*.

According to one example, the memory cell 1900 may be written to (i.e., programmed) in the following manner. The second word line *WL_{1B}* and the passgate transistor's gate 1902 may be electrically coupled to the nominal supply voltage *V_{DD}* thereby turning on (i.e., making conductive) the passgate transistor 1901 (e.g., where the supply voltage *V_{DD}* is greater than the transistor's 1901 threshold voltage *V_{TH}*). The bit line *BL₁* and the passgate transistor's second source/drain terminal 1904b may be electrically coupled to a programming voltage *Vpp* that is greater than or equal to the gate dielectric breakdown voltage *V_{BD}* (e.g., *V_{BDGSD}*) of the antifuse 700. Since the passgate transistor 1901 is conductive, the source/drain terminals 704a, 704b are also at the programming voltage *V_{PP}.* The first word line *WL_{1A}* and the antifuse's gate terminal 702 may be electrically coupled to ground *V_{SS}*. The voltage potential (Vpp) across the source/drain terminals 704a, 704b and the gate terminal 702 of the antifuse 700 causes the gate dielectric 708 of the antifuse 702 to break down (i.e., antifuse 700 transitions from open circuit state to closed circuit state) and creates a short circuit path between the first word line *WL_{1A}* and the bit line *BL₁*. Thus, a current will flow from the higher potential (e.g., *V_{PP}*) bit line *BL₁* through the passgate transistor's source/drain terminals 1904a, 1904b, through one or more of the antifuse's source/drain terminals 704a, 704b, and through the antifuse's metal gate terminal 702 to the first word line *WL_{1A}.* The closed circuit state of the antifuse 700 may correspond to one logical value (e.g., a "one") whereas the open circuit state may correspond to another logical value (e.g., a "zero").

According to one example, the memory cell 1900 may be read in the following manner. The second word line *WL_{1B}* and the passgate transistor's gate 1902 may be electrically coupled to the nominal supply voltage *V_{DD}* thereby turning on (i.e., making conductive) the passgate transistor 1901 (e.g., where the supply voltage *V_{DD}* is greater than the transistor's 1901 threshold voltage *V_{TH}*). The bit line *BL₁* and the passgate transistor's second source/drain terminal 1904b may be electrically coupled to ground *V_{SS}*. Since the passgate transistor 1901 is conductive, the source/drain terminals 704a, 704b are also at ground *V_{SS}*. The first word line *WL_{1A}* and the antifuse's gate terminal 702 may be electrically coupled to a read voltage *V_{RD}* (e.g., *V_{RD}* may equal the nominal supply voltage *V_{DD}*). As such, the antifuse's gate terminal 702 may be at a higher voltage potential (*V_{RD}*) than the source/drain terminals 704a, 704b, and consequently, the polarity of the read voltage *V_{RD}* is oriented opposite to the built-in electric field *E_{BIGSD}*.

If the antifuse 700 has been previously programmed such that the antifuse 700 is in a closed circuit state (i.e., the gate dielectric has been broken down), then a significant amount of current will flow from the higher potential (*V_{RD}*) first word line *WL_{1A}* through the antifuse's metal gate terminal 702, through one or more of the antifuse's source/drain terminals 704a and/or 704b, and through the passgate transistor's source/drain terminals 1904a, 1904b to the lower potential (e.g., ground *V_{SS}*) bit line *BL₁*. However, if the antifuse 700 has not been previously programmed and is still in an open state (i.e., the gate dielectric has not been broken down), then a negligible leakage current may flow from the first word line *WL_{1A}* through the antifuse's metal gate terminal 702, through one or more of the antifuse's source/drain terminals 704a and/or 704b, and through the passgate transistor's source/drain terminals 1904a, 1904b to the lower potential bit line *BL₁*. Sensing circuitry electrically coupled to the bit line *BL₁* detects the amount of current flow, and based on whether it is significant or negligible, it may determine the logical state of the antifuse 700.

In one aspect, *V_{PP}* is greater than or equal to *V_{DD}.* According to another aspect, *V_{PP}* may be equal to the highest input/output (I/O) voltage available on the IC having the memory cell 1900. According to yet another aspect, the antifuse 700 may be permanently programmed such that antifuse 700 cannot revert back to an open circuit state once closed.

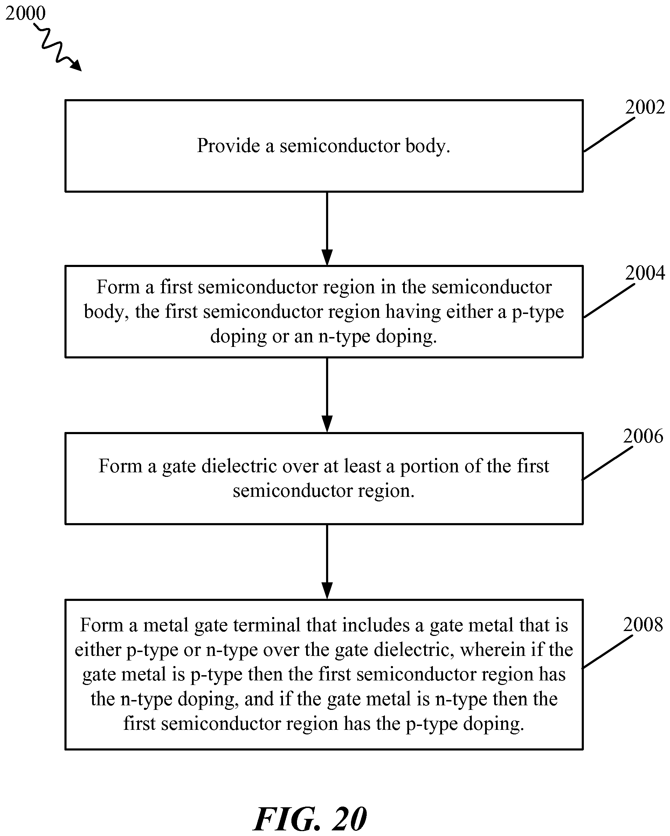

FIG. 20 illustrates a flowchart 2000 for a method of manufacturing an integrated circuit according to one aspect of the disclosure. At step 2002, a semiconductor body is provided. At step 2004, a first semiconductor region is formed in the semiconductor body, where the first semiconductor region has either a p-type doping or an n-type doping. At step 2006, a gate dielectric is formed over at least a portion of the first semiconductor region. At step 2008, a metal gate terminal is formed that includes a gate metal that is either p-type or n-type over the gate dielectric, wherein if the gate metal is p-type then the first semiconductor region has the n-type doping, and if the gate metal is n-type then the first semiconductor region has the p-type doping.

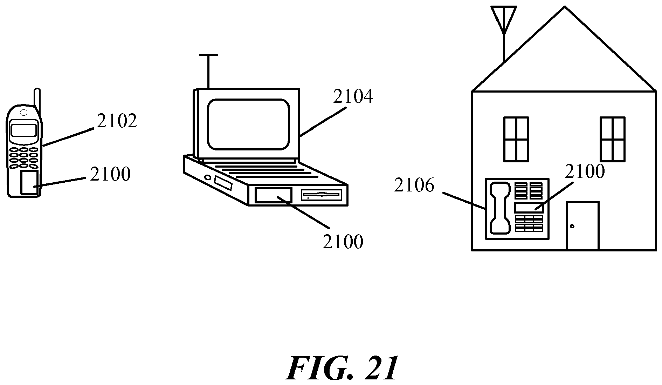

FIG. 21 illustrates various electronic devices that may include an integrated circuit 2100. The integrated circuit 2100 may be any one of the antifuses 200, 600, 700, 1100 and/or memory cells 1800, 1900 described above with respect to FIGS. 2, 3, 4, 5, 6, 7, 8, 9, 10, 11, 12, 13, 14, 15, 16, 17, 18, 19, and/or 20. For example, a mobile telephone 2102, a laptop computer 2104, and a fixed location terminal 2106 may include the integrated circuit 2100. The devices 2102, 2104, 2106 illustrated in FIG. 21 are merely exemplary. Other electronic devices may also feature the integrated circuit 2100 including, but not limited to, hand-held personal communication systems (PCS) units, portable data units such as personal data assistants, GPS enabled devices, navigation devices, set top boxes, music players, video players, entertainment units, fixed location data units such as meter reading equipment, or any other device that stores or retrieves data or computer instructions, or any combination thereof.

One or more of the components, steps, features, and/or functions illustrated in FIGS. 2, 3, 4, 5, 6, 7, 8, 9, 10, 11, 12, 13, 14, 15, 16, 17, 18, 19, 20, and/or 21 may be rearranged and/or combined into a single component, step, feature or function or embodied in several components, steps, or functions. Additional elements, components, steps, and/or functions may also be added without departing from the invention.

Also, it is noted that the aspects of the present disclosure may be described as a process that is depicted as a flowchart, a flow diagram, a structure diagram, or a block diagram. Although a flowchart may describe the operations as a sequential process, many of the operations can be performed in parallel or concurrently. In addition, the order of the operations may be re-arranged. A process is terminated when its operations are completed. A process may correspond to a method, a function, a procedure, a subroutine, a subprogram, etc.

## Claims

1. An integrated circuit antifuse (200) comprising:
a metal gate terminal (202) that includes a gate metal that is either p-type or n-type;
a first semiconductor region (204a, 204b) having either a p-type doping or an n-type doping, such that if the gate metal is p-type then the first semiconductor region has the n-type doping, and if the gate metal is n-type then the first semiconductor region has the p-type doping, wherein the first semiconductor region is a source/drain region that underlies a portion of the metal gate terminal (202) such that an opposing polarity of the metal gate terminal (202) and the source/drain region generates an intrinsic electric field at a boundary (212) between the metal gate terminal (202) and the source/drain region;
an oxide layer having an approximately planar surface interposed between the metal gate terminal and the first semiconductor region; and
a gate dielectric (208) interposed between the metal gate terminal (202) and the oxide layer, such that when a voltage is applied in parallel to the intrinsic electric field, the total electric field at the boundary (212) increases.

2. The integrated circuit antifuse of claim 1, further comprising a semiconductor substrate body comprising a second surface approximately parallel to the planar surface, the semiconductor substrate body having either a p-type doping or an n-type doping, such that if the gate metal is p-type then the substrate body has the p-type doping, and if the gate metal is n-type then the substrate body has the n-type doping, the first semiconductor region disposed in the semiconductor substrate body, wherein a portion of the first semiconductor region is below a first portion of the metal gate terminal, and wherein the oxide layer is interposed between the gate dielectric and the semiconductor substrate body.

3. The integrated circuit antifuse of claim 2, further comprising a second semiconductor region having either a p-type doping or an n-type doping, such that if the gate metal is p-type then the second semiconductor region has the n-type doping, and if the gate metal is n-type then the second semiconductor region has the p-type doping, the second semiconductor region disposed in the semiconductor substrate body, wherein a portion of the second semiconductor region is below a second portion of the metal gate terminal, and wherein the oxide layer is interposed between the gate dielectric and the second semiconductor region.

4. The integrated antifuse circuit of claim 2, further comprising a short trench isolation barrier disposed in the semiconductor substrate body, a portion of the short trench isolation barrier below a second portion of the metal gate terminal, wherein the oxide layer is interposed between the gate dielectric and the short trench isolation barrier.

5. The integrated circuit antifuse of claim 1, wherein the gate dielectric is a high-*K* dielectric material having a dielectric constant greater than or equal to ten.

6. The integrated circuit antifuse of claim 1, wherein the gate dielectric comprises at least one of hafnium oxide, HfO₂, hafnium silicon oxide, HfSiO, and/or hafnium silicate, HfSiO₄.

7. The integrated circuit antifuse of claim 1, wherein the gate metal is p-type, and wherein the gate metal comprises at least one of titanium nitride, TiN, and/or titanium carbide, TiC.

8. The integrated circuit antifuse of claim 1, wherein the gate metal is n-type, and wherein the gate metal comprises at least one of titanium aluminum nitride (TiAIN), titanium aluminide, TiAl, zirconium aluminide, ZrAl, and/or tungsten aluminide, WAl.

9. The integrated circuit antifuse of claim 1, further comprising a spacer coupled to a sidewall of the metal gate terminal and in direct contact with a portion of the first semiconductor region, wherein a first gate breakdown voltage at a boundary region between the metal gate terminal and the first semiconductor region is less than a second gate breakdown voltage at a boundary region between the metal gate terminal and a semiconductor substrate body.

10. The integrated circuit antifuse of claim 1, wherein the metal gate terminal, the first semiconductor region, the oxide layer, and the gate dielectric are included in the antifuse, wherein the gate dielectric is adapted to breakdown and to create a conductive path between the metal gate terminal and the first semiconductor region when a programming voltage between the metal gate terminal and the first semiconductor region is equal to or exceeds a gate breakdown voltage at a boundary region between the metal gate terminal and the first semiconductor region, and wherein a probability that the conductive path forms at the boundary region between the metal gate terminal and the first semiconductor region is about ten times greater than a probability that the conductive path forms at a boundary region between the metal gate terminal and a semiconductor substrate body below the gate dielectric.

11. The integrated circuit antifuse of claim 1, wherein the metal gate terminal, the first semiconductor region, the oxide layer, and the gate dielectric are included in the antifuse that is included in a one-time programmable memory, OTP, circuit, and wherein the gate dielectric is adapted to breakdown and to create a conductive path that is irreversible.

12. The integrated circuit antifuse of claim 1, wherein the metal gate terminal, the first semiconductor region, the oxide layer, and the gate dielectric are included in the antifuse that is included in a multi-time programmable memory, MTP, circuit, and wherein the gate dielectric is adapted to breakdown and to create a conductive path that is reversible.

13. The integrated circuit antifuse of claim 1, wherein if the gate metal is p-type then the first semiconductor region has an n+-type doping and if the gate metal is n-type then the first semiconductor region has a p+-type doping, and wherein a portion of the first semiconductor region having either the p+-type doping or the n+-type doping is located vertically under a first portion of the metal gate terminal.

14. The integrated circuit antifuse of claim 1, wherein the gate dielectric is adapted to breakdown and to create a conductive path, wherein a probability that the conductive path forms at a first boundary region between the metal gate terminal and the first semiconductor region is at least about five times greater than a probability that the conductive path forms at a second boundary region between the metal gate terminal and a semiconductor substrate body below the gate dielectric, and wherein a gate breakdown voltage at the first boundary region is reduced in proportion to a built-in electric field associated with the first boundary region.

15. The integrated circuit antifuse of claim 1, wherein the oxide layer does not extend underneath a sidewall spacer of the metal gate terminal, and wherein a programming voltage between the metal gate terminal and the first semiconductor region is reduced if a polarity of the programming voltage is oriented approximately parallel to a built-in electric field associated with a boundary region between the metal gate terminal and the first semiconductor region.

16. The integrated circuit antifuse of claim 1, wherein the metal gate terminal, the first semiconductor region, the oxide layer, and the gate dielectric are included in the antifuse, wherein a logical value stored at the antifuse is adapted to be read when a voltage equal to or exceeding a read voltage is applied between the first semiconductor region and the metal gate terminal, the voltage applied having a polarity oriented opposite to a built-in electric field associated with a boundary region between the metal gate terminal and the first semiconductor region.

17. The integrated circuit antifuse of claim 1, wherein the metal gate terminal, the first semiconductor region, the oxide layer, and the gate dielectric are incorporated into at least one of a music player, a video player, an entertainment unit, a navigation device, a communications device, a mobile phone, a smartphone, a personal digital assistant, a fixed location terminal, a tablet computer, and/or a laptop computer.

18. A method (2000) of manufacturing an integrated circuit antifuse, the method comprising:
forming (2004) a first semiconductor region in a semiconductor substrate body, the first semiconductor region having either a p-type doping or an n-type doping;
forming an oxide layer having an approximately planar surface over at least a portion of the first semiconductor region;
forming (2006) a gate dielectric over the oxide layer;
forming (2008) a metal gate terminal over the gate dielectric, wherein the metal gate terminal includes a gate metal that is either p-type or n-type over the gate dielectric, wherein if the gate metal is p-type then the first semiconductor region has the n-type doping, and if the gate metal is n-type then the first semiconductor region has the p-type doping, wherein the first semiconductor region is a source/drain region that underlies a portion of the metal gate terminal (202) such that an opposing polarity of the metal gate terminal (202) and the source/drain region generates an intrinsic electric field at a boundary (212) between the metal gate terminal (202) and the source/drain region; and
applying a voltage in parallel to the intrinsic electric field such that the total electric field at the boundary (212) increases.

19. The method of claim 18, further comprising, prior to forming the metal gate terminal:
forming a polysilicon layer over the oxide layer;
removing a portion of the polysilicon layer to form a dummy gate, wherein the first semiconductor region is formed after the dummy gate is formed and prior to the metal gate being formed; and
after the first semiconductor region is formed, removing the dummy gate to create a cavity, wherein removing the dummy gate exposes the oxide layer.

20. The method of claim 19, wherein the gate dielectric is formed in the cavity and on the oxide layer, wherein the gate dielectric is distinct from the oxide layer, and wherein the oxide layer is silicon dioxide, silicon oxynitride, or a combination thereof.

21. The method of claim 20, wherein if the gate metal is p-type then the first semiconductor region has an n+-type doping and if the gate metal is n-type then the first semiconductor region has a p+-type doping, and wherein a first portion of the metal gate terminal is formed vertically over a portion of the first semiconductor region having either the p+-type doping or the n+-type doping.

## Patentansprüche

1. Ein Integrierte-Schaltung-Antifuse (200), aufweisend:
einen Metal-Gate-Anschluss (202), der ein Gate-Metall enthält, das vom p-Typ oder n-Typ ist,
einen ersten Halbleiterbereich (204a, 204b), der eine p-Typ-Dotierung oder eine n-Typ-Dotierung aufweist, sodass, wenn das Gate-Metall vom p-Typ ist, der erste Halbleiterbereich die n-Typ-Dotierung aufweist, und wenn das Gate-Metall vom n-Typ ist, der erste Halbleiterbereich die p-Typ-Dotierung aufweist, wobei der erste Halbleiterbereich ein Source/Drain-Bereich ist, der unter einem Teil des Metal-Gate-Anschlusses (202) liegt, sodass eine entgegengesetzte Polarität des Metal-Gate-Anschlusses (202) und des Source/Drain-Bereichs ein intrinsisches elektrisches Feld an einer Grenze (212) zwischen dem Metal-Gate-Anschluss (202) und dem Source/Drain-Bereich erzeugt,
eine Oxidschicht mit einer annähernd planaren Fläche, die zwischen dem Metal-Gate-Anschluss und dem ersten Halbleiterbereich angeordnet ist, und
ein Gate-Dielektrikum (208), das zwischen dem Metal-Gate-Anschluss (202) und der Oxidschicht angeordnet ist, sodass, wenn eine Spannung parallel zu dem intrinsischen elektrischen Feld angelegt wird, das gesamte elektrische Feld an der Grenze (212) größer wird.

2. Integrierte-Schaltung-Antifuse nach Anspruch 1, das weiterhin einen Halbleitersubstratkörper aufweist, der eine zweite Fläche annähernd parallel zu der planaren Fläche aufweist, wobei der Halbleitersubstratkörper eine p-Typ-Dotierung oder eine n-Typ-Dotierung aufweist, sodass, wenn das Gate-Metall vom p-Typ ist, der Substratkörper die p-Typ-Dotierung aufweist, und wenn das Gate-Metall vom n-Typ ist, der Substratkörper die n-Typ-Dotierung aufweist, wobei der erste Halbleiterbereich in dem Halbleitersubstratkörper angeordnet ist, wobei ein Teil des ersten Halbleiterbereichs unter einem ersten Teil des Metal-Gate-Anschlusses angeordnet ist und wobei die Oxidschicht zwischen dem Gate-Dielektrikum und dem Halbleitersubstratkörper angeordnet ist.

3. Integrierte-Schaltung-Antifuse nach Anspruch 2, das weiterhin einen zweiten Halbleiterbereich aufweist, der eine p-Typ-Dotierung oder eine n-Typ-Dotierung aufweist, sodass, wenn das Gate-Metall vom p-Typ ist, der zweite Halbleiterbereich die n-Typ-Dotierung aufweist, und wenn das Gate-Metall vom n-Typ ist, der zweite Halbleiterbereich die p-Typ-Dotierung aufweist, wobei der zweite Halbleiterbereich in dem Halbleitersubstratkörper angeordnet ist, wobei ein Teil des zweiten Halbleiterbereichs unter einem zweiten Teil des Metal-Gate-Anschlusses angeordnet ist und wobei die Oxidschicht zwischen dem Gate-Dielektrikum und dem zweiten Halbleiterbereich angeordnet ist.

4. Integrierte-Schaltung-Antifuse nach Anspruch 2, das weiterhin eine Kurze-Grabenisolation-Grenze aufweist, die in dem Halbleitersubstratkörper angeordnet ist, wobei ein Teil der Kurze-Grabenisolation-Grenze unter einem zweiten Teil des Metal-Gate-Anschlusses angeordnet ist und wobei die Oxidschicht zwischen dem Gate-Dielektrikum und der Kurze-Grabenisolation-Grenze angeordnet ist.

5. Integrierte-Schaltung-Antifuse nach Anspruch 1, wobei das Gate-Dielektrikum ein dielektrisches Material mit einer hohen dielektrischen Konstante K größer oder gleich zehn ist.

6. Integrierte-Schaltung-Antifuse nach Anspruch 1, wobei das Gate-Dielektrikum Hafniumoxid (HfO₂), Hafniumsiliciumoxid (HfSiO) und/oder Hafniumsilikat HfSiO₄ aufweist.

7. Integrierte-Schaltung-Antifuse nach Anspruch 1, wobei das Gate-Metall vom p-Typ ist und wobei das Gate-Metall Titannitrid (TiN) und/oder Titancarbid (TiC) aufweist.

8. Integrierte-Schaltung-Antifuse nach Anspruch 1, wobei das Gate-Metall vom n-Typ ist und das Gate-Metall Titanaluminiumnitrid (TiAlN), Titanaluminid (TiAl), Zirkoniumaluminid (ZrAl) und/oder Wolframaluminid (WAl) aufweist.

9. Integrierte-Schaltung-Antifuse nach Anspruch 1, das weiterhin ein Abstandsglied aufweist, das mit einer Seitenwand des Metal-Gate-Anschlusses gekoppelt ist und in direktem Kontakt mit einem Teil des ersten Halbleiterbereichs ist, wobei eine erste Gate-Durchbruchsspannung an einem Grenzbereich zwischen dem Metal-Gate-Anschluss und dem ersten Halbleiterbereich kleiner als eine zweite Gate-Durchbruchsspannung an einem Grenzbereich zwischen dem Metal-Gate-Anschluss und einem Halbleitersubstratkörper ist.

10. Integrierte-Schaltung-Antifuse nach Anspruch 1, wobei der Metal-Gate-Anschluss, der erste Halbleiterbereich, die Oxidschicht und das Gate-Dielektrikum in dem Antifuse enthalten sind, wobei das Gate-Dielektrikum ausgebildet ist zum Durchbrechen und zum Herstellen eines leitenden Pfads zwischen dem Metal-Gate-Anschluss und dem ersten Halbleiterbereich, wenn eine Programmierspannung zwischen dem Metal-Gate-Anschluss und dem ersten Halbleiterbereich gleich oder größer als eine Gate-Durchbruchsspanung an einem Grenzbereich zwischen dem Metal-Gate-Anschluss und dem ersten Halbleiterbereich ist, und wobei die Wahrscheinlichkeit, dass der leitende Pfad an dem Grenzbereich zwischen der Metal-Gate-Anschluss und dem ersten Halbleiterbereich hergestellt wird, ungefähr zehnmal größer ist als die Wahrscheinlichkeit, dass der leitende Pfad an einem Grenzbereich zwischen dem Metal-Gate-Anschluss und einem Halbleitersubstratkörper unter dem Gate-Dielektrikum hergestellt wird.

11. Integrierte-Schaltung-Antifuse nach Anspruch 1, wobei der Metal-Gate-Anschluss, der erste Halbleiterbereich, die Oxidschicht und das Gate-Dielektrikum in dem Antifuse enthalten sind, das in einer Einmaligprogrammierbarer-Speicher (One-Time Programmable Memory bzw. OTP)-Schaltung enthalten ist, und wobei das Gate-Dielektrikum ausgebildet ist zum Durchbrechen und zum Herstellen eines leitenden Pfads, der irreversibel ist.

12. Integrierte-Schaltung-Antifuse nach Anspruch 1, wobei der Metal-Gate-Anschluss, der erste Halbleiterbereich, die Oxidschicht und das Gate-Dielektrikum in dem Antifuse enthalten sind, das in einem Mehrfachprogrammierbarer-Speicher (Multi-Time Programmable Memory bzw. MTP)-Schaltung enthalten ist, und wobei das Gate-Dielektrikum ausgebildet ist zum Durchbrechen und zum Herstellen eines leitenden Pfads, der irreversibel ist.

13. Integrierte-Schaltung-Antifuse nach Anspruch 1, wobei, wenn das Gate-Metall vom p-Typ ist, der erste Halbleiterbereich eine n+-Typ-Dotierung aufweist, und wenn das Gate-Metall vom n-Typ ist, der erste Halbleiterbereich eine p+-Typ-Dotierung aufweist, und wobei ein Teil des ersten Halbleiterbereichs, der die p+-Typ-Dotierung oder die n+-Typ-Dotierung aufweist, vertikal unter einem ersten Teil des Metal-Gate-Anschlusses angeordnet ist.

14. Integrierte-Schaltung-Antifuse nach Anspruch 1, wobei das Gate-Dielektrikum ausgebildet ist zum Durchbrechen und Herstellen eines leitenden Pfads, wobei die Wahrscheinlichkeit, dass der leitende Pfad einen ersten Grenzbereich zwischen dem Metal-Gate-Anschluss und dem ersten Halbleiterbereich bildet, wenigstens fünfmal größer ist als die Wahrscheinlichkeit, dass der leitende Pfad einen zweiten Grenzbereich zwischen dem Metal-Gate-Anschluss und einem Halbleitersubstratkörper unter dem Gate-Dielektrikum bildet, wobei eine Gate-Durchbruchsspannung an dem ersten Grenzbereich proportional zu einem eingebauten elektrischen Feld, das mit dem ersten Grenzbereich assoziiert ist, reduziert ist.

15. Integrierte-Schaltung-Antifuse nach Anspruch 1, wobei sich die Oxidschicht nicht unter einem Seitenwand-Abstandsglied des Metal-Gate-Anschlusses erstreckt und wobei eine Programmierspannung zwischen dem Metal-Gate-Anschluss und dem ersten Halbleiterbereich reduziert ist, wenn die Polarität der Programmierspannung annähernd parallel zu einem eingebauten elektrischen Feld ist, das mit einem Grenzbereich zwischen dem Metal-Gate-Anschluss und dem ersten Halbleiterbereich assoziiert ist.

16. Integrierte-Schaltung-Antifuse nach Anspruch 1, wobei der Metal-Gate-Anschluss, der erste Halbleiterbereich, die Oxidschicht und das Gate-Dielektrikum in dem Antifuse enthalten sind, wobei ein an dem Antifuse gespeicherter logischer Wert ausgebildet ist, um gelesen zu werden, wenn eine Spannung gleich oder größer als eine Lesespannung zwischen dem ersten Halbleiterbereich und dem Metal-Gate-Anschluss angelegt wird, wobei die angelegte Spannung eine Polarität aufweist, die entgegengesetzt zu einem eingebauten elektrischen Feld ist, das mit einem Grenzbereich zwischen dem Metal-Gate-Anschluss und dem ersten Halbleiterbereich assoziiert ist.

17. Integrierte-Schaltung-Antifuse nach Anspruch 1, wobei der Metal-Gate-Anschluss, der erste Halbleiterbereich, die Oxidschicht und das Gate-Dielektrikum in ein Musikwiedergabegerät, ein Videowiedergabegerät, eine Unterhaltungseinheit, ein Navigationsgerät, ein Kommunikationsgerät, ein Mobiltelefon, ein Smartphone, einen PDA, ein Endgerät mit einer fixen Position, einen Tablet-Computer und/oder einen Laptop-Computer integriert sind.

18. Ein Verfahren (2000) zum Herstellen eines Integrierte-Schaltung-Antifuses, wobei das Verfahren aufweist:
Ausbilden (2004) eines ersten Halbleiterbereichs in einem Halbleitersubstratkörper, wobei der erste Halbleiterbereich eine p-Typ-Dotierung oder eine n-Typ-Dotierung aufweist,
Ausbilden einer Oxidschicht mit einer annähernd planaren Fläche über wenigstens einem Teil des ersten Halbleiterbereichs,
Ausbilden (2006) eines Gate-Dielektrikums über der Oxidschicht,
Ausbilden (2008) eines Metal-Gate-Anschlusses über dem Gate-Dielektrikum, wobei der Metal-Gate-Anschluss ein Gate-Metall vom p-Typ oder n-Typ über dem Gate-Dielektrikum enthält, wobei, wenn das Gate-Metall vom p-Typ ist, der erste Halbleiterbereich die n-Typ-Dotierung aufweist, und wenn das Gate-Metall vom n-Typ ist, der erste Halbleiterbereich die p-Typ-Dotierung aufweist, wobei der erste Halbleiterbereich ein Source/Drain-Bereich ist, der unter einem Teil des Metal-Gate-Anschlusses (202) liegt, sodass eine entgegengesetzte Polarität des Metal-Gate-Anschlusses (202) und des Source/Drain-Bereichs ein intrinsisches elektrisches Feld an einer Grenze (212) zwischen dem Metal-Gate-Anschluss (202) und dem Source/Drain-Bereich erzeugt, und
Anlegen einer Spannung parallel zu dem intrinsischen elektrischen Feld derart, dass das gesamte elektrische Feld an der Grenze (212) größer wird.

19. Verfahren nach Anspruch 18, das weiterhin vor dem Ausbilden des Metal-Gate-Anschlusses aufweist:
Ausbilden einer Polysiliciumschicht über der Oxidschicht,
Entfernen eines Teils der Polysiliciumschicht, um ein Dummy-Gate zu bilden, wobei der erste Halbleiterbereich nach dem Ausbilden des Dummy-Gates und vor dem Ausbilden des Metall-Gates ausgebildet wird, und
nachdem der erste Halbleiterbereich ausgebildet wurde, Entfernen des Dummy-Gates, um einen Hohlraum zu erzeugen, wobei durch das Entfernen des Dummy-Gates die Oxidschicht freigelegt wird.

20. Verfahren nach Anspruch 19, wobei das Gate-Dielektrikum in dem Hohlraum und auf der Oxidschicht ausgebildet wird, wobei das Gate-Dielektrikum verschieden ist von der Oxidschicht und wobei die Oxidschicht aus Siliciumdioxid, Siliciumoxynitrid oder einer Kombination aus diesen besteht.

21. Verfahren nach Anspruch 20, wobei, wenn das Gate-Metall von p-Typ ist, der erste Halbleiterbereich eine n+-Typ-Dotierung aufweist, und wenn das Gate-Metall vom n-Typ ist, der erste Halbleiterbereich eine p+-Typ-Dotierung aufweist, und wobei ein erster Teil des Metal-Gate-Anschlusses vertikal über einem Teil des ersten Halbleiterbereichs mit der p+-Typ-Dotierung oder der n+-Typ-Dotierung ausgebildet wird.

## Revendications

1. Un anti-fusible de circuit intégré (200) comprenant :
une borne de grille métallique (202) qui comprend un métal de grille qui est soit de type p ou de type n,
une première zone à semi-conducteur (204a, 204b) possédant soit un dopage de type p ou un dopage de type n, de sorte que, si le métal de grille est de type p, alors la première zone à semi-conducteur possède le dopage de type n et si le métal de grille est de type n, alors la première zone à semi-conducteur possède le dopage de type p, où la première zone à semi-conducteur est une zone de source/drain qui se situe sous une partie de la borne de grille métallique (202) de sorte qu'une polarité opposée de la borne de grille métallique (202) et de la zone de source/drain génère un champ électrique intrinsèque au niveau d'une limite (212) entre la borne de grille métallique (202) et la zone de source/drain,
une couche d'oxyde possédant une surface approximativement plane interposée entre la borne de grille métallique et la première zone à semi-conducteur, et
un diélectrique de grille (208) interposé entre la borne de grille métallique (202) et la couche d'oxyde, de sorte que, lorsqu'une tension est appliquée en parallèle au champ électrique intrinsèque, le champ électrique total au niveau de la limite (212) augmente.

2. L'anti-fusible de circuit intégré selon la Revendication 1, comprenant en outre un corps de substrat à semi-conducteur comprenant une deuxième surface approximativement parallèle à la surface plane, le corps de substrat à semi-conducteur possédant soit un dopage de type p ou un dopage de type n, de sorte que, si le métal de grille est de type p, alors le corps de substrat possède le dopage de type p et si le métal de grille est de type n, alors le corps de substrat possède le dopage de type n, la première zone à semi-conducteur disposée dans le corps de substrat à semi-conducteur, où une partie de la première zone à semi-conducteur est sous une première partie de la borne de grille métallique, et où la couche d'oxyde est interposée entre le diélectrique de grille et le corps de substrat à semi-conducteur.

3. L'anti-fusible de circuit intégré selon la Revendication 2, comprenant en outre une deuxième zone à semi-conducteur possédant soit un dopage de type p ou un dopage de type n, de sorte que, si le métal de grille est de type p, alors la deuxième zone à semi-conducteur possède le dopage de type n et si le métal de grille est de type n, alors la deuxième zone à semi-conducteur possède le dopage de type p, la deuxième zone à semi-conducteur disposée dans le corps de substrat à semi-conducteur, où une partie de la deuxième zone à semi-conducteur est sous une deuxième partie de la borne de grille métallique, et où la couche d'oxyde est interposée entre le diélectrique de grille et la deuxième zone à semi-conducteur.

4. Le anti-fusible de circuit intégré selon la Revendication 2, comprenant en outre une barrière d'isolation à tranchée courte disposée dans le corps de substrat à semi-conducteur, une partie de la barrière d'isolation à tranchée courte sous une deuxième partie de la borne de grille métallique, où la couche d'oxyde est interposée entre le diélectrique de grille et la barrière d'isolation à tranchée courte.

5. L'anti-fusible de circuit intégré selon la Revendication 1, où le diélectrique de grille est un matériau diélectrique à *K* élevé possédant une constante diélectrique supérieure ou égale à dix.

6. L'anti-fusible de circuit intégré selon la Revendication 1, où le diélectrique de grille contient au moins un élément parmi oxyde de hafnium, HfO₂, oxyde de silicium de hafnium, HfSiO, et/ou silicate de hafnium, HfSiO₄.

7. L'anti-fusible de circuit intégré selon la Revendication 1, où le métal de grille est de type p et où le métal de grille contient au moins un élément parmi nitrure de titane, TiN, et/ou carbure de titane, TiC.

8. L'anti-fusible de circuit intégré selon la Revendication 1, où le métal de grille est de type n et où le métal de grille contient au moins un élément parmi nitrure d'aluminium et de titane (TiAlN), aluminure de titane, TiAl, aluminure de zirconium, ZrAl, et/ou aluminure de tungstène, WAl.

9. L'anti-fusible de circuit intégré selon la Revendication 1, comprenant en outre une entretoise couplée à une paroi latérale de la borne de grille métallique et en contact direct avec une partie de la première zone à semi-conducteur, où une première tension de claquage de grille au niveau d'une zone limite entre la borne de grille métallique et la première zone à semi-conducteur est inférieure à une deuxième tension de claquage de grille au niveau d'une zone limite entre la borne de grille métallique et un corps de substrat à semi-conducteur.

10. L'anti-fusible de circuit intégré selon la Revendication 1, où la borne de grille métallique, la première zone à semi-conducteur, la couche d'oxyde et le diélectrique de grille sont inclus dans l'anti-fusible, où le diélectrique de grille est adapté de façon à claquer et à créer un trajet conducteur entre la borne de grille métallique et la première zone à semi-conducteur lorsqu'une tension de programmation entre la borne de grille métallique et la première zone à semi-conducteur est égale à ou dépasse une tension de claquage de grille au niveau d'une zone limite entre la borne de grille métallique et la première zone à semi-conducteur, et où une probabilité que le trajet conducteur se forme au niveau de la zone limite entre la borne de grille métallique et la première zone à semi-conducteur est environ dix fois supérieure à une probabilité que le trajet conducteur se forme au niveau d'une zone limite entre la borne de grille métallique et un corps de substrat à semi-conducteur sous le diélectrique de grille.

11. L'anti-fusible de circuit intégré selon la Revendication 1, où la borne de grille métallique, la première zone à semi-conducteur, la couche d'oxyde et le diélectrique de grille sont inclus dans l'anti-fusible qui est inclus dans un circuit à mémoire programmable une seule fois, OTP, et où le diélectrique de grille est adapté de façon à claquer et à créer un trajet conducteur qui est irréversible.

12. L'anti-fusible de circuit intégré selon la Revendication 1, où la borne de grille métallique, la première zone à semi-conducteur, la couche d'oxyde et le diélectrique de grille sont inclus dans l'anti-fusible qui est inclus dans un circuit à mémoire programmable plusieurs fois, MTP, et où le diélectrique de grille est adapté de façon à claquer et à créer un trajet conducteur qui est réversible.

13. L'anti-fusible de circuit intégré selon la Revendication 1, où, si le métal de grille est de type p, alors la première zone à semi-conducteur possède un dopage de type n+ et si le métal de grille est de type n, alors la première zone à semi-conducteur possède un dopage de type p+, et où une partie de la première zone à semi-conducteur possédant soit le dopage de type p+ ou le dopage de type n+ est placée verticalement sous une première partie de la borne de grille métallique.

14. L'anti-fusible de circuit intégré selon la Revendication 1, où le diélectrique de grille est adapté de façon à claquer et à créer un trajet conducteur, où une probabilité que le trajet conducteur se forme au niveau d'une première zone limite entre la borne de grille métallique et la première zone à semi-conducteur est au moins environ cinq fois supérieure à une probabilité que le trajet conducteur se forme au niveau d'une deuxième zone limite entre la borne de grille métallique et un corps de substrat à semi-conducteur sous le diélectrique de grille, et où une tension de claquage de grille au niveau de la première zone limite est réduite en proportion à un champ électrique intégré associé à la première zone limite.

15. L'anti-fusible de circuit intégré selon la Revendication 1, où la couche d'oxyde ne s'étend pas sous une entretoise de paroi latérale de la borne de grille métallique, et où une tension de programmation entre la borne de grille métallique et la première zone à semi-conducteur est réduite si une polarité de la tension de programmation est orientée approximativement parallèlement à un champ électrique intégré associé à une zone limite entre la borne de grille métallique et la première zone à semi-conducteur.

16. L'anti-fusible de circuit intégré selon la Revendication 1, où la borne de grille métallique, la première zone à semi-conducteur, la couche d'oxyde et le diélectrique de grille sont inclus dans l'anti-fusible, où une valeur logique conservée en mémoire au niveau de l'anti-fusible est adaptée de façon à être lue lorsqu'une tension égale à ou dépassant une tension de lecture est appliquée entre la première zone à semi-conducteur et la borne de grille métallique, la tension appliquée possédant une polarité orientée à l'opposé d'un champ électrique intégré associé à une zone limite entre la borne de grille métallique et la première zone à semi-conducteur.

17. L'anti-fusible de circuit intégré selon la Revendication 1, où la borne de grille métallique, la première zone à semi-conducteur, la couche d'oxyde et le diélectrique de grille sont incorporés dans au moins un dispositif parmi un lecteur de musique, un lecteur vidéo, une unité de divertissement, un dispositif de navigation, un dispositif de communication, un téléphone mobile, un téléphone multifonction, un assistant numérique personnel, un terminal à emplacement fixe, un ordinateur tablette et/ou un ordinateur portatif.

18. Un procédé (2000) de fabrication d'un anti-fusible de circuit intégré, le procédé comprenant :
la formation (2004) d'une première zone à semi-conducteur dans un corps de substrat à semi-conducteur, la première zone à semi-conducteur possédant soit un dopage de type p ou un dopage de type n,
la formation d'une couche d'oxyde possédant une surface approximativement plane sur au moins une partie de la première zone à semi-conducteur,
la formation (2006) d'un diélectrique de grille sur la couche d'oxyde,
la formation (2008) d'une borne de grille métallique sur le diélectrique de grille, où la borne de grille métallique comprend un métal de grille qui est soit de type p ou de type n sur le diélectrique de grille, où, si le métal de grille est de type p, alors la première zone à semi-conducteur possède le dopage de type n et si le métal de grille est de type n, alors la première zone à semi-conducteur possède le dopage de type p, où la première zone à semi-conducteur est une zone de source/drain qui se situe sous une partie de la borne de grille métallique (202) de sorte qu'une polarité opposée de la borne de grille métallique (202) et de la zone de source/drain génère un champ électrique intrinsèque au niveau d'une limite (212) entre la borne de grille métallique (202) et la zone de source/drain, et
l'application d'une tension en parallèle au champ électrique intrinsèque de sorte que le champ électrique total au niveau de la limite (212) augmente.

19. Le procédé selon la Revendication 18, comprenant en outre, avant la formation de la borne de grille métallique :
la formation d'un couche de polysilicium sur la couche d'oxyde,
le retrait d'une partie de la couche de polysilicium de façon à former une grille factice, où la première zone à semi-conducteur est formée après la formation de la grille factice et avant la formation de la grille métallique, et
après la formation de la première zone à semi-conducteur, le retrait de la grille factice de façon à créer une cavité, où le retrait de la grille factice expose la couche d'oxyde.

20. Le procédé selon la Revendication 19, où le diélectrique de grille est formé dans la cavité et sur la couche d'oxyde, où le diélectrique de grille est distinct de la couche d'oxyde, et où la couche d'oxyde est dioxyde de silicium, oxynitrure de silicium, ou une combinaison de ceux-ci.

21. Le procédé selon la Revendication 20, où, si le métal de grille est de type p, alors la première zone à semi-conducteur possède un dopage de type n+ et si le métal de grille est de type n, alors la première zone à semi-conducteur possède un dopage de type p+, et où une première partie de la borne de grille métallique est formée verticalement sur une partie de la première zone à semi-conducteur possédant soit le dopage de type p+ ou le dopage de type n+.
